# EUROPEAN PATENT APPLICATION

(11) **EP 4 445 764 A1**
(43) Date of publication of application: **16.10.2024**
(21) Application number: 21967260.7
(22) Date of filing: 10.12.2021
(51) Int. Cl.: A24F 40/40

(54) **POWER SUPPLY UNIT FOR AEROSOL GENERATING DEVICE**

(71) Applicant: Japan Tobacco Inc., Tokyo 105-6927 (JP)
(72) Inventor: MARUBASHI, Keiji, Tokyo 130-8603 (JP); KITAHARA, Minoru, Tokyo 130-8603 (JP)
(74) Representative: Hoffmann Eitle
(86) International application number: PCT/JP2021/045594
(87) International publication number: WO 2023/105768

(57) **Abstract**

The present invention reduces the size of a power supply unit for an aerosol generating device mounted with a switch. A power supply unit 100 comprises: a power source ba; an MCU 6 configured to be able to control power supply from the power source ba to an atomizer that atomizes an aerosol source; a main FPC 23; and a switch BT operable by a user and electrically connected to the MCU 6. The switch BT is directly mounted on the main FPC 23.

## Description

### TECHNICAL FIELD

The present invention relates to a power supply unit for an aerosol generating device.

### BACKGROUND ART

Patent Literature 1 discloses an aerosol generation device including a heater, a battery that supplies electric power to allow heating of the heater, a control unit, and a main PCB and a sub PCB which are made of a rigid material, in which the main PCB is disposed parallel to a longitudinal direction of the aerosol generation device, the sub PCB is disposed perpendicular to the longitudinal direction of the aerosol generation device, and the main PCB and the sub PCB are electrically connected by a connection PCB made of a soft material.

Patent Literature 2 discloses an aerosol generation device including a circuit substrate on which a switch to be operated by a user is mounted.

Patent Literature 3 discloses an electronic aerosol supply system including a flexible flat cable and a temperature sensor located adjacent to a battery and incorporated in the flexible flat cable in order to sense a temperature of the battery.

### CITATION LIST

### PATENT LITERATURE

Patent Literature 1: JP2020-531015A
Patent Literature 2: WO 2020/213451
Patent Literature 3: JP2020-518250A

### SUMMARY OF INVENTION

### TECHNICAL PROBLEM

The aerosol generating device is preferably provided with a switch that can be operated by a user in order to improve usability. However, when the switch is directly mounted on a circuit substrate for control, an area occupied by the switch on the circuit substrate becomes large. In addition, when a circuit substrate dedicated to the switch is provided, a size of a housing for accommodating the circuit substrate is increased.

An object of the present invention is to reduce a size of a power supply unit for an aerosol generating device on which a switch is mounted.

### SOLUTION TO PROBLEM

A power supply unit for an aerosol generating device according to an embodiment of the present invention includes:
a power supply;
a controller configured to control supply of electric power from the power supply to an atomizer that atomizes an aerosol source;
a flexible circuit substrate; and
a switch operable by a user and electrically connected to the controller, in which
the switch is directly mounted on the flexible circuit substrate.

### ADVANTAGEOUS EFFECTS OF INVENTION

According to the present invention, a reduction in size is possible.

### BRIEF DESCRIPTION OF DRAWINGS

[FIG. 1] FIG. 1 is a perspective view of an aerosol generating device 200.
[FIG. 2]FIG. 2 is another perspective view of the aerosol generating device 200.
[FIG. 3] FIG. 3 is an exploded perspective view of the aerosol generating device 200.
[FIG. 4] FIG. 4 is a left side view of an internal unit 2A.
[FIG. 5] FIG. 5 is a right side view of the internal unit 2A.
[FIG. 6] FIG. 6 is a perspective view showing a configuration of a heating unit 60 and a circuit unit 70 of the internal unit 2A.
[FIG. 7] FIG. 7 is a view showing a front surface 201 of a main substrate 20.
[FIG. 8] FIG. 8 is a view showing a back surface 202 of the main substrate 20.
[FIG. 9] FIG. 9 is a diagram showing a schematic configuration of a circuit provided in the main substrate 20.
[FIG. 10] FIG. 10 is a circuit diagram showing electronic components related to an operation in a heating mode and extracted from the circuit shown in FIG. 9.
[FIG. 11] FIG. 11 is a circuit diagram showing electronic components related to a heating control of a sheet heater HTR and a liquid heater, a driving control of a vibration motor 13, and a driving control of an LED 21D and extracted from the circuit shown in FIG. 9.
[FIG. 12] FIG. 12 is a circuit diagram showing electronic components related to restart of an MCU 6 and extracted from the circuit shown in FIG. 9.
[FIG. 13] FIG. 13 is a front view of a main FPC 23 as viewed from a left side when the main FPC 23 is developed such that a thickness direction thereof coincides with a left-right direction.
[FIG. 14] FIG. 14 is a front view of the main FPC 23 as viewed from a right side when the main FPC 23 is developed such that the thickness direction thereof coincides with the left-right direction.
[FIG. 15] FIG. 15 is an enlarged view of a range AR shown in FIG. 14.

### DESCRIPTION OF EMBODIMENTS

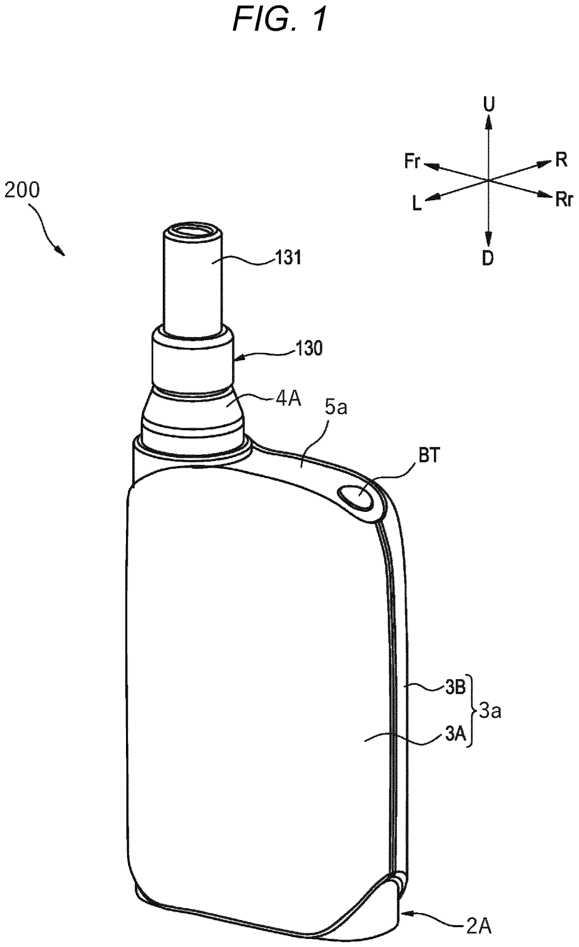

Hereinafter, a power supply unit for an aerosol generating device according to an embodiment of the present invention will be described. First, an aerosol generating device including a power supply unit of the present embodiment will be described with reference to FIGs. 1 to 8.

### (Aerosol Generating Device)

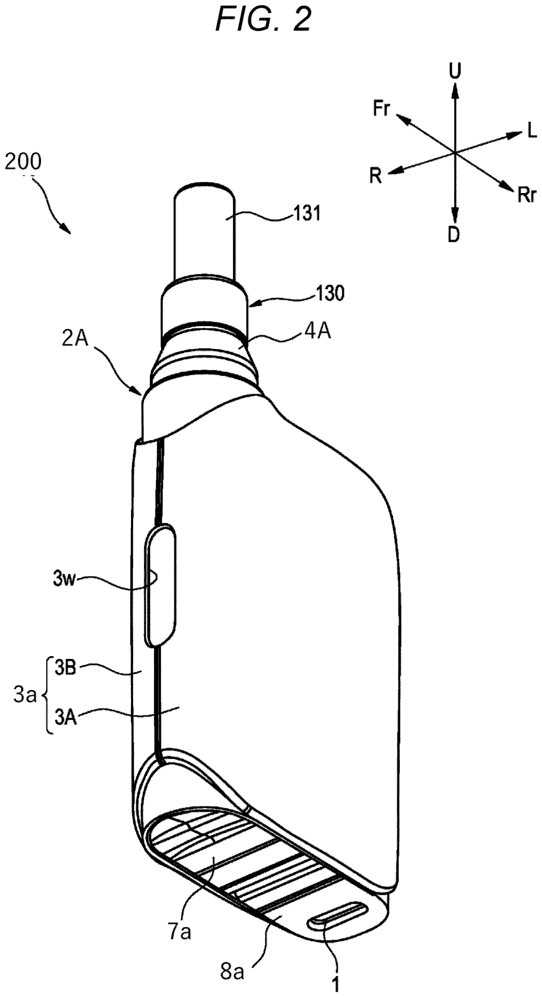

An aerosol generating device 200 is a device for generating flavored aerosol without combustion and inhaling the generated aerosol. The aerosol generating device 200 preferably has a size that fits in hands, and for example, as shown in FIGs. 1 and 2, has a rounded, substantially rectangular parallelepiped shape. The shape of the aerosol generating device 200 is not limited thereto, and may be a bar shape, an egg shape, or the like. In the following description, three directions orthogonal to one another in the aerosol generating device 200 are referred to as an upper-lower direction, a front-rear direction, and a left-right direction in descending order of length. In the following description, for convenience, as shown in FIGs. 1 to 8, front, rear, left, right, upper, and lower are defined, a front side is denoted by Fr, a rear side is denoted by Rr, a left side is denoted by L, a right side is denoted by R, an upper side is denoted by U, and a lower side is denoted by D.

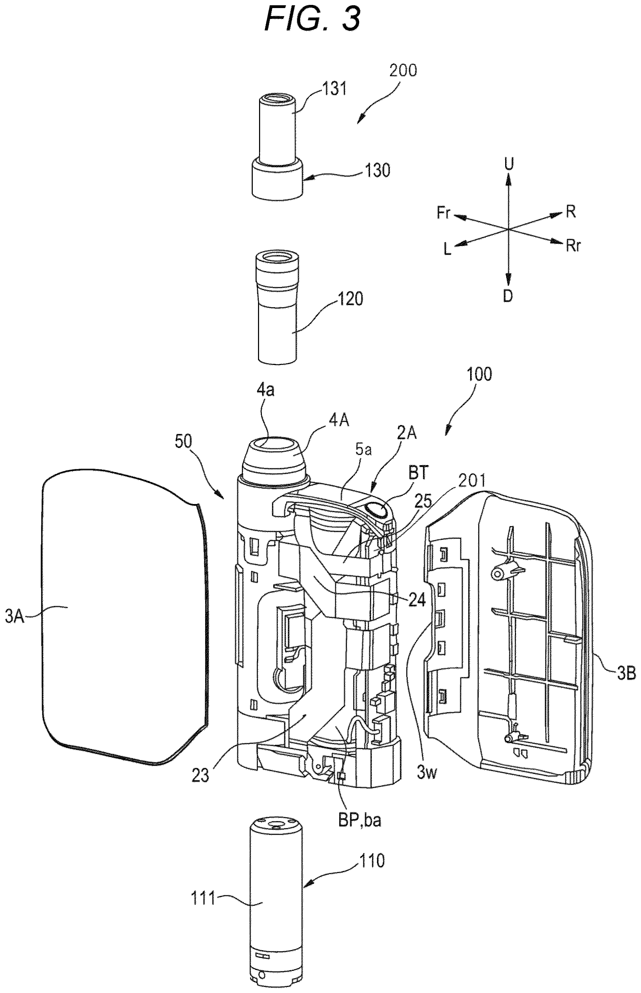

Referring also to FIG. 3, the aerosol generating device 200 includes a power supply unit 100, a first cartridge 110, and a second cartridge 120. The first cartridge 110 and the second cartridge 120 are attachable to and detachable from the power supply unit 100. In other words, the first cartridge 110 and the second cartridge 120 are replaceable.

### (Power Supply Unit)

The power supply unit 100 includes an internal unit 2A and a case 3a, and at least a part of the internal unit 2A is accommodated in the case 3a.

The case 3a includes a first case 3A and a second case 3B that are detachable in the left-right direction (thickness direction), the first case 3A and the second case 3B are assembled in the left-right direction (thickness direction), thereby forming a front surface, a rear surface, a left surface, and a right surface of the power supply unit 100. Specifically, the first case 3A is supported on a left surface of a chassis 50 to be described later in the internal unit 2A, the second case 3B is supported on a right surface of the chassis 50, and the internal unit 2A is accommodated in the case 3. A capsule holder 4A is provided on a front side on the upper surface of the power supply unit 100. The capsule holder 4Ais provided with an opening portion 4a that is opened upward. The capsule holder 4A is configured such that the second cartridge 120 may be inserted through the opening portion 4a. On the second cartridge 120, a mouth piece 130 is detachably provided.

The upper surface of the power supply unit 100 is formed by an organic light-emitting diode (OLED) cover 5a disposed behind the opening portion 4a, and the lower surface of the power supply unit 100 is formed by a pivotable lower lid 7a and a lower cover 8a provided with a charging terminal 1.

An inclined surface inclined downward toward the rear is provided between the upper surface and the rear surface of the power supply unit 100. The inclined surface is provided with an operation unit operable by a user. The operation unit of the present embodiment is a button-type switch BT, but may be implemented by a touch panel or the like. The operation unit is used to start/shut off/operate a micro controller unit (MCU) 6 and various sensors, which will be described later, based on a use intention of the user.

The charging terminal 1 accessible from the lower cover 8a is configured to be electrically connected to an external power supply (not shown) capable of supplying electric power to the power supply unit 100 to charge a power supply ba provided in a battery pack BP. The charging terminal 1 is, for example, a receptacle into which a mating plug can be inserted. As the charging terminal 1, a receptacle into which various USB terminals or the like can be inserted may be used. As an example, in the present embodiment, the charging terminal 1 is a USB Type-C receptacle.

The charging terminal 1 may include, for example, a power receiving coil, and may be configured to receive electric power transmitted from the external power supply in a noncontact manner. In this case, a method for wireless power transfer (WPT) may be of an electromagnetic induction type, a magnetic resonance type, or a combination of the electromagnetic induction type and the magnetic resonance type. As another example, the charging terminal 1 may be connectable to various USB terminals or the like, and may include the above-described power receiving coil.

As shown in FIGs. 3 to 6, the internal unit 2Aincludes the battery pack BP, the chassis 50, a heating unit 60, a circuit unit 70, a notification unit, and various sensors.

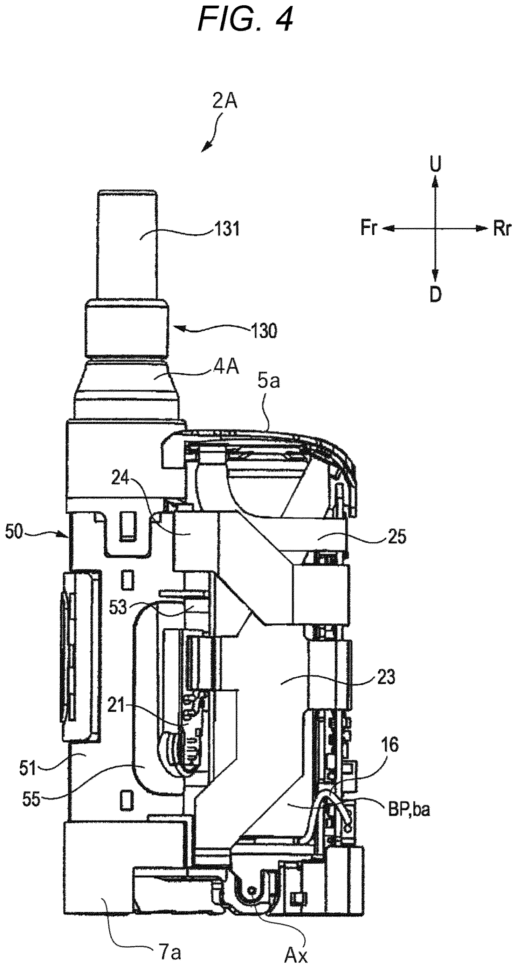

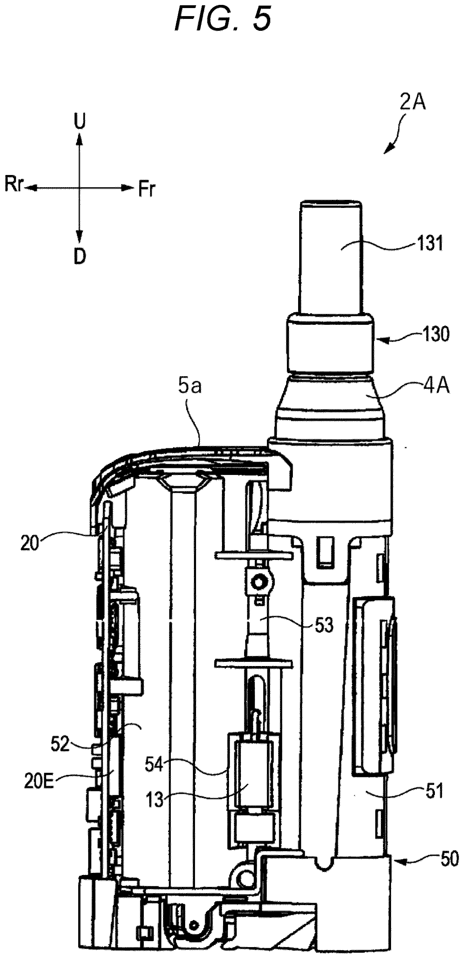

As shown in FIGs. 4 and 5, the chassis 50 includes a cylindrical cartridge holding portion 51 located on a front side, a half-cylindrical battery holding portion 52 located on a rear side and having a left side cut out, a plate-shaped coupling portion 53 coupling the cartridge holding portion 51 and the battery holding portion 52, a motor holding portion 54 provided below and on a right side of the coupling portion 53 in a manner of straddling the cartridge holding portion 51 and the battery holding portion 52, and a sensor holding portion 55 provided on a left rear side of the cartridge holding portion 51.

The first cartridge 110 is inserted into the cartridge holding portion 51 from below in a state where the lower lid 7a is opened. When the lower lid 7a is closed in a state where the first cartridge 110 is inserted, the first cartridge 110 is accommodated in the cartridge holding portion 51. The capsule holder 4A is attached to an upper portion of the cartridge holding portion 51. In the cartridge holding portion 51, a vertically long through hole is provided on a front side, and a remaining amount of an aerosol source of the first cartridge 110 and light of a light emitting diode (LED) 21D to be described later can be visually observed through a remaining amount confirmation window 3w provided at a joint of the first case 3A and the second case 3B. The first cartridge 110 will be described later.

The battery pack BP is disposed in the battery holding portion 52. The battery pack BP includes the power supply ba and a power supply thermistor for detecting a temperature of the power supply ba. The power supply ba is a chargeable secondary battery, an electric double-layer capacitor, or the like, and is preferably a lithium ion secondary battery. An electrolyte of the power supply ba may be constituted by one or a combination of a gel electrolyte, an electrolytic solution, a solid electrolyte, and an ionic liquid.

A vibration motor 13 is disposed in the motor holding portion 54. An inhalation sensor 15 to be described later, which provides an output in response to an inhalation operation (puff operation) of the user, is disposed in the sensor holding portion 55.

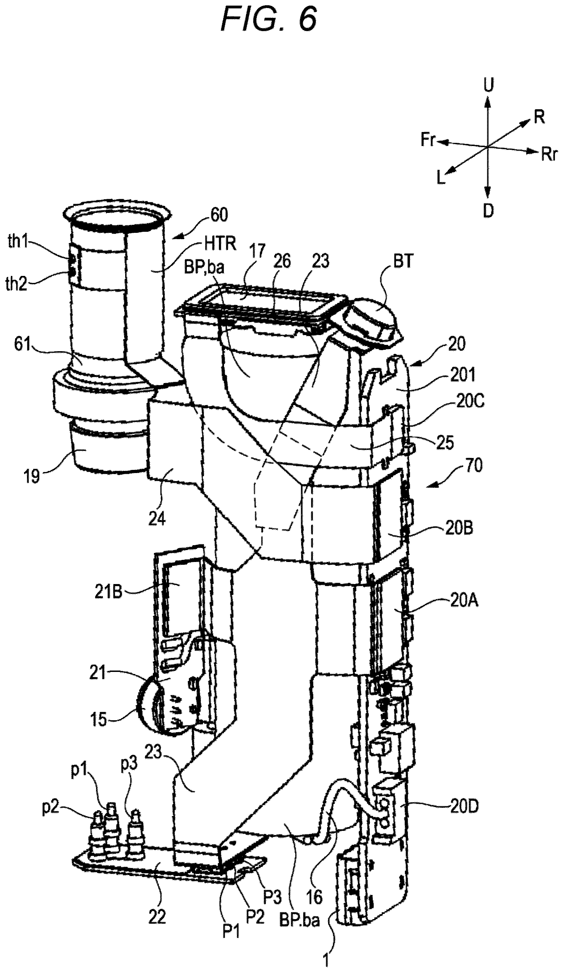

As shown in FIG. 6, the heating unit 60 includes a cylindrical heat transfer tube 61 and a sheet heater HTR wound around an outer periphery of the heat transfer tube 61. The capsule holder 4Ais separately provided around the sheet heater HTR. An air layer between the capsule holder 4A and the sheet heater HTR functions as a heat insulator. A lower portion of the second cartridge 120 inserted from the opening portion 4a of the capsule holder 4A is accommodated in the heat transfer tube 61, and a lower portion of the second cartridge 120 is heated by the sheet heater HTR. Accordingly, as compared with a case where the heating unit 60 is not provided, a flavor source stored in the second cartridge 120 easily releases a flavor, so that the aerosol is easily flavored.

The heating unit 60 may be an element capable of heating the second cartridge 120. Examples of the element include a resistance heating element, a ceramic heater, and an induction-heating-type heater. As the resistance heating element, for example, a heating element having a positive temperature coefficient (PTC) characteristic in which an electrical resistance value increases as the temperature increases is preferably used. Alternatively, a heating element having a negative temperature coefficient (NTC) characteristic in which the electrical resistance value decreases as the temperature increases may be used. The heating unit 60 has a function of defining a flow path of air to be supplied to the second cartridge 120 and a function of heating the second cartridge 120.

The notification unit issues notifications about various kinds of information such as a charging state of the power supply ba, a remaining amount of the first cartridge 110, and a remaining amount of the second cartridge 130. The notification unit of the present embodiment includes the LED 21D and the vibration motor 13. The notification unit may be implemented by a light emitting element such as the LED 21D, a vibration element such as the vibration motor 13, or a sound output element. The notification unit may be a combination of two or more elements among the light emitting element, the vibration element, and the sound output element.

The various sensors include the inhalation sensor 15 that detects the puff operation (inhalation operation) of the user, a heater temperature sensor that detects a temperature of the sheet heater HTR, and the like.

The inhalation sensor 15 includes, for example, a capacitor microphone, a pressure sensor, and a flow rate sensor. A plurality of inhalation sensors 15 may be disposed apart from each other, and the puff operation may be detected based on a difference between output values of the inhalation sensors 15. The heater temperature sensor includes a first thermistor th1 and a second thermistor th2. The first thermistor th1 and the second thermistor th2 are preferably in contact with or close to the sheet heater HTR. When the sheet heater HTR has the PTC characteristic or the NTC characteristic, the sheet heater HTR may be used for the heater temperature sensor. The heater temperature sensor includes two thermistors, but may include one thermistor.

The circuit unit 70 includes four circuit substrates, three flexible printed circuits (FPCs) or flexible printed circuit substrates, a plurality of integrated circuits (ICs), and a plurality of elements. The four circuit substrates include a main substrate 20, the puff sensor substrate 21, a pogo pin substrate 22, and an OLED substrate 26. The three FPCs include a main FPC 23, a heater FPC 24, and an OLED FPC 25. The four circuit substrates are rigid and have sufficiently higher rigidity than the three FPCs.

The main substrate 20 is disposed between the battery pack BP and a rear surface of the case 3a (the rear surface of the power supply unit 100) such that an element mounting surface faces the front-rear direction. The main substrate 20 is configured by laminating a plurality of layers (six layers in the present embodiment) of substrates, and electronic components (elements) such as the MCU 6 and a charging IC 3 are mounted thereon.

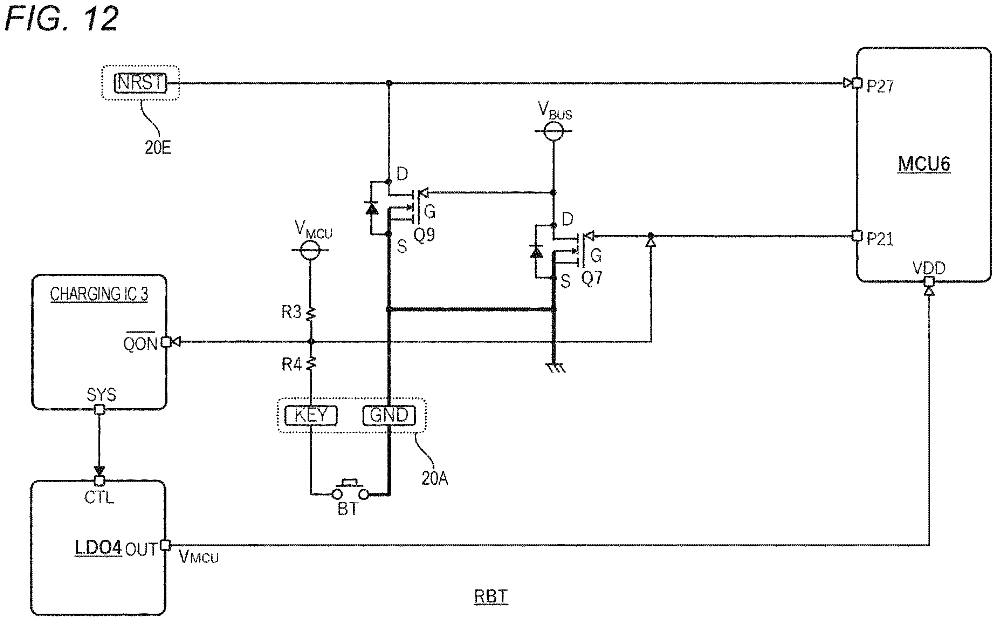

As to be described later in detail with reference to FIG. 12 and the like, the MCU 6 is a control device that is connected to various sensor devices such as the inhalation sensor 15, the operation unit, the notification unit, and a memory or the like that stores the number of times of puff operations, a load, an energization time to the sheet heater HTR, and the like, and performs various controls of the aerosol generating device 200. Specifically, the MCU 6 is implemented by a processor as a main component, and further includes a storage medium such as a random access memory (RAM) necessary for an operation of the processor and a read only memory (ROM) storing various kinds of information. For example, the processor in the present description is an electrical circuit in which circuit elements such as semiconductor devices are combined. A part of the elements (for example, the inhalation sensor 15 and the memory) connected to the MCU 6 may be provided inside the MCU 6 as a function of the MCU 6 itself.

The charging IC 3 is an IC that performs charging control of the power supply ba by the electric power received via the charging terminal 1, and supplies the electric power of the power supply ba to the electronic components and the like on the main substrate 20.

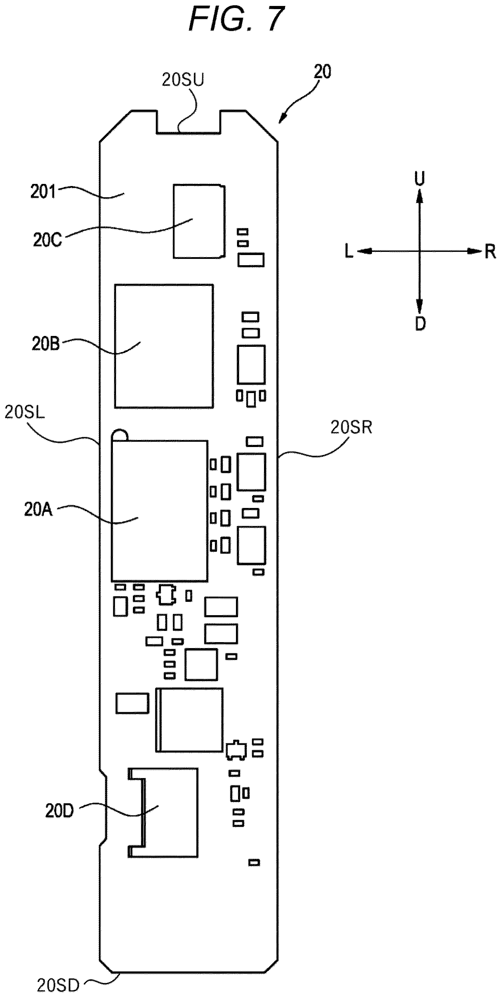

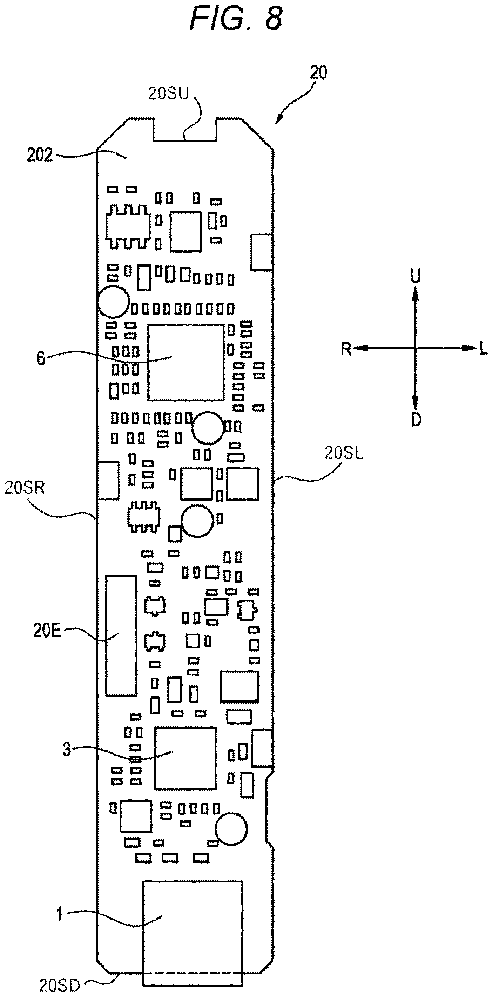

The main substrate 20 will be described more specifically with reference to FIGs. 7 and 8. Hereinafter, a surface of the main substrate 20 facing rearward is referred to as a front surface 201 for convenience, and a surface of the main substrate 20 facing forward is referred to as a back surface 202 for convenience. FIG. 7 is a diagram showing the front surface 201 of the main substrate 20, and FIG. 8 is a diagram showing the back surface 202 of the main substrate 20. The main substrate 20 has a plate shape extending vertically, and FIGs. 7 and 8 show an upper side surface 20SU which is a side surface on an upper side and a lower side surface 20SD which is a side surface on a lower side, as side surfaces orthogonal to a longitudinal direction of the main substrate 20. A left side surface 20SL which is a side surface on a left side and a right side surface 20SR which is a side surface on a right side are shown as side surfaces orthogonal to a short direction of the main substrate 20.

As shown in FIG. 8, the MCU 6 and the charging IC 3 are mounted on the back surface 202 of the main substrate 20 together with the charging terminal 1. A debug connector 20E is further mounted on the back surface 202. The debug connector 20E is an interface for rewriting a program of the MCU 6 from an external device such as a personal computer, and for example, a connector conforming to a Serial Wire Debug (SWD) standard is used. Meanwhile, as shown in FIG. 7, an OLED connector 20C, a heater connector 20B, a main connector 20A, and a battery connector 20D which is connected to the battery pack BP via a lead wire 16 (see FIG. 6) are mounted on the front surface 201 of the main substrate 20.

As shown in FIGs. 4 and 6, the puff sensor substrate 21 is disposed on the sensor holding portion 55 of the chassis 50 such that an element mounting surface faces a right front side and a left rear side. The inhalation sensor 15 is mounted on the puff sensor substrate 21.

As shown in FIG. 6, the OLED substrate 26 is disposed between the battery pack BP and the OLED cover 5a such that an element mounting surface faces the upper-lower direction. An OLED panel 17 is mounted on the OLED substrate 26.

As shown in FIG. 6, the pogo pin substrate 22 is disposed on the lower lid 7a such that an element mounting surface faces the upper-lower direction in a state where the lower lid 7a is closed. The pogo pin substrate 22 is provided with input-side contact points P1 to P3 to which electric power is supplied from the main substrate 20 via the main FPC 23, pogo pins p1 to p3 which are connectors electrically connected to a load provided in the first cartridge 110, and wirings connecting the pogo pins p1 to p3 and the input-side contact points P1 to P3. The input-side contact points P1 to P3 are electrically connected to the main FPC 23 only in a state where the lower lid 7a is closed. The three pogo pins p1 to p3 are provided at equal intervals in a peripheral direction, and at least two pogo pins are electrically connected to a positive terminal and a negative terminal of the first cartridge 110 accommodated in the cartridge holding portion 51.

A left side of the battery pack BP held by the battery holding portion 52 is exposed from the battery holding portion 52 due to the half-cylindrical battery holding portion 52. As shown in FIGs. 3, 4, and 6, the main FPC 23, the heater FPC 24, and the OLED FPC 25 are disposed to overlap one another in a space between the left side of the battery pack BP and the first case 3A, which is formed by cutting out the battery holding portion 52.

Among the three FPCs, the main FPC 23 is routed closest to battery pack BP, the OLED FPC 25 is routed to partially overlap the main FPC 23, and further the heater FPC 24 is routed to overlap the OLED FPC 25. That is, the heater FPC 24 to which the largest electric power is supplied among the three FPCs is routed to be farthest from the battery pack BP. The main FPC 23 has a developed shape of a substantially cross shape, and is folded rearward at a position overlapping the heater FPC 24. That is, the main FPC 23 has a folded wiring. Although the folded portion of the main FPC 23 is likely to float in the left-right direction, the heater FPC 24 and the OLED FPC 25 overlap this portion, thereby preventing such floating. The switch BT is directly mounted on the main FPC 23 without using a rigid substrate or the like.

The OLED FPC 25 has one end connected to the OLED connector 20C of the main substrate 20 and the other end connected to the OLED substrate 26.

The main FPC 23 connects the main connector 20A of the main substrate 20, the switch BT of the operation unit, a connector 21B of the puff sensor substrate 21, and the input-side contact points P1 to P3 of the pogo pin substrate 22.

The heater FPC 24 has one end connected to the heater connector 20B of the main substrate 20, and the other end integrally formed with the sheet heater HTR.

### (First Cartridge)

The first cartridge 110 includes, inside a cylindrical cartridge case 111, a reservoir that stores an aerosol source, an electrical load that atomizes the aerosol source, a wick that draws the aerosol source from the reservoir to the load, and an aerosol flow path through which aerosol generated by atomization of the aerosol source flows toward the second cartridge 120. The aerosol source contains a liquid such as glycerin, propylene glycol, or water.

The load is a heating element that heats, without combustion, the aerosol source by electric power supplied from the power supply ba via the pogo pins p1 to p3 of the pogo pin substrate 22, and is implemented by, for example, a heating wire (coil) wound at a predetermined pitch. The load atomizes the aerosol source by heating the aerosol source. As the load, a heating resistor, a ceramic heater, an induction-heating-type heater, and the like may be used. Hereinafter, the load provided in the first cartridge 110 is also referred to as a liquid heater.

The aerosol flow path is connected to the second cartridge 120 via a flow path forming body 19 (see FIG. 6) accommodated in the cartridge holding portion 51 of the chassis 50.

### (Second Cartridge)

The second cartridge 120 stores a flavor source. When the second cartridge 120 is heated by the sheet heater HTR, the flavor source is heated. The second cartridge 120 flavors the aerosol when the aerosol generated by atomizing the aerosol source by the liquid heater passes through the flavor source. As a raw material piece constituting the flavor source, it is possible to use a molded product obtained by molding a shredded tobacco or a tobacco raw material into granules. The flavor source may be formed of plants other than tobacco (for example, mint, Chinese medicine, and herb). The flavor source may contain a fragrance such as menthol.

The aerosol generating device 200 may generate flavored aerosol using the aerosol source and the flavor source. That is, the aerosol source and the flavor source constitute an aerosol generating source that generates the flavored aerosol.

The aerosol generating source in the aerosol generating device 200 is a portion to be replaced for use by the user. In this portion, for example, one first cartridge 110 and one or a plurality of (for example, five) second cartridges 120 are provided as a set to the user. The battery pack BP may be repeatedly charged and discharged as long as the power supply ba is not significantly deteriorated. Accordingly, in the aerosol generating device 200, a replacement frequency of the power supply unit 100 or the battery pack BP is lowest, a replacement frequency of the first cartridge 110 is second lowest, and a replacement frequency of the second cartridge 120 is highest. The first cartridge 110 and the second cartridge 120 may be integrated into one cartridge. Instead of the flavor source, a chemical agent or the like may be added to the aerosol source.

In the aerosol generating device 200 configured as described above, air flowing in from an air intake port (not shown) provided in the case 3a or the internal unit 2A passes near the load of the first cartridge 110. The load atomizes the aerosol source drawn from the reservoir by the wick. The aerosol generated by atomization flows through the aerosol flow path together with the air flowing in from the intake port, and is supplied to the second cartridge 120 via the flow path forming body 19. The aerosol supplied to the second cartridge 120 is flavored when passing through the flavor source, and is supplied to an inhalation port 131 of the mouth piece 130.

Next, a configuration of the lower lid 7a will be additionally described.

The lower lid 7a is configured to pivot around a rotation axis Ax extending in the left-right direction shown in FIG. 4. Specifically, the lower lid 7a is brought into an open state (a state in which a hollow portion of the cartridge holding portion 51 is exposed) by moving a front end counterclockwise from a closed state (a state in which the hollow portion of the cartridge holding portion 51 is covered) shown in FIG. 4. As shown in FIG. 6, the pogo pin substrate 22 has a flat plate shape, and the input-side contact points P1 to P3 each of which is implemented by a protrusion protruding upward are provided at a rear end of an upper surface of the pogo pin substrate 22. Further, on a front end of the upper surface of the pogo pin substrate 22, the pogo pins p1 to p3 each of which is implemented by a protrusion protruding upward are provided. The pogo pin substrate 22 is fixed to an inner surface (upper surface) of the lower lid 7a. When the lower lid 7a is in the closed state, the input-side contact points P1 to P3 of the pogo pin substrate 22 are in contact with terminals 81T to 83T of conductive patterns 81 to 83 provided on the main FPC 23 to be described later, and an electrical connection between the main FPC 23 and the pogo pin substrate 22 is established. On the other hand, when the lower lid 7a is in the open state, the input-side contact points P1 to P3 of the pogo pin substrate 22 are separated from the terminals 81T to 83T of the conductive patterns 81 to 83 and are not in contact with the conductive patterns 81 to 83. That is, the electrical connection between the main FPC 23 and the pogo pin substrate 22 is released. The main FPC 23 is accommodated inside the case 3 so as not to be deformed due to opening and closing operation of the lower lid 7a. The main FPC 23 being not deformed means that a position of the main FPC 23 inside the case 3 is not substantially changed.

Thus, the lower lid 7a and the pogo pin substrate 22 fixed thereto are portions to which a force is applied when the first cartridge 110 is inserted into and removed from the cartridge holding portion 51. In the present embodiment, the pogo pin substrate 22 is implemented by a rigid circuit substrate. By using a rigid circuit substrate which is inexpensive and rigid at such a position, durability of the power supply unit 100 may be improved.

In the present embodiment, the electrical connection between the pogo pin substrate 22 and the main FPC 23 is established only when the lower lid 7a is in the closed state. Accordingly, the main FPC 23 is less likely to be damaged as compared with a case where the main FPC 23 is interlocked with pivoting of the lower lid 7a.

In the present embodiment, when the first cartridge 110 is inserted and removed, an electrical contact is not established between the main substrate 20 or the power supply ba and the first cartridge 110. Therefore, an unintended short-circuit current is less likely to occur, and safety of the power supply unit 100 may be improved.

Further, in the present embodiment, each of the input-side contact points P1 to P3 to be brought into contact with the main FPC 23 is implemented by a protrusion with a small contact area. Therefore, an external force applied to the main FPC 23 when the lower lid 7a is opened and closed and stress generated by the external force may be reduced.

In the present embodiment, when the second cartridge 120 is inserted into and removed from the capsule holder 4A, the insertion of the first cartridge 110 is unnecessary. That is, the lower lid 7a needs to be opened and closed in order to insert and remove the first cartridge 110 whose replacement frequency is lower than that of the second cartridge 120. Accordingly, the lower lid 7a can be prevented from being frequently opened and closed, and the durability of the power supply unit 100 may be improved.

### (Circuit Structure)

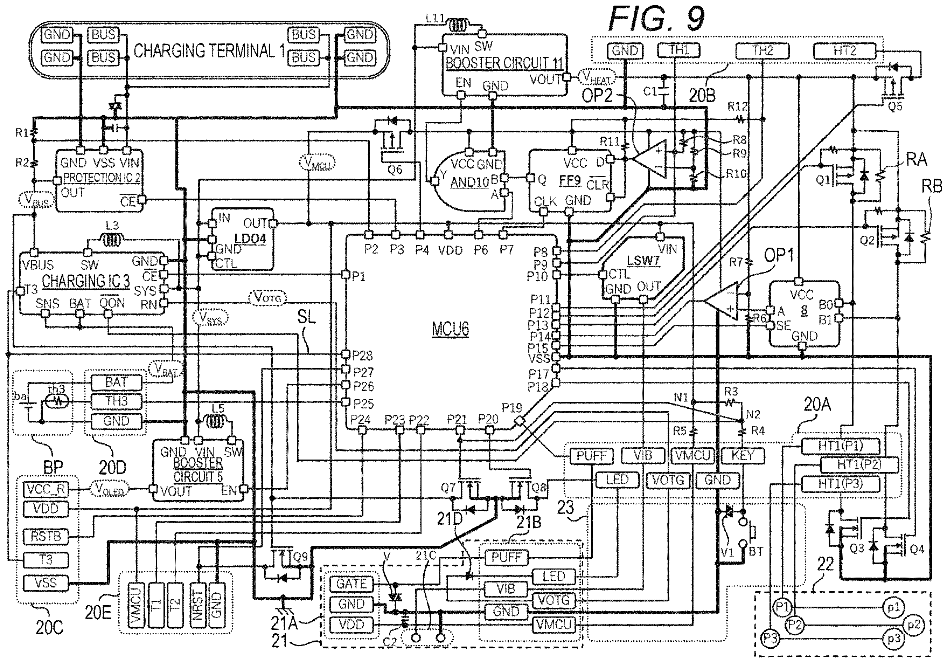

FIG. 9 is a diagram showing a schematic configuration of a circuit provided in the main substrate 20. In addition to the circuit of the main substrate 20, FIG. 9 shows the main FPC 23 connected to the main connector 20A of the main substrate 20, the puff sensor substrate 21 connected to the main FPC 23, the pogo pin substrate 22 connected to the main FPC 23, and the battery pack BP connected to the battery connector 20D.

A wiring indicated by a thick solid line in FIG. 9 is a wiring having the same potential as a reference potential (a ground potential, 0 V as an example below) of the power supply unit 100 (a wiring connected to a ground provided in the power supply unit 100), and the wiring is hereinafter referred to as a ground line.

The main substrate 20 is provided with, as main ICs which are electronic components in each of which a plurality of circuit elements are formed into a chip, a protection IC 2; the charging IC 3; a low dropout (LDO) regulator (hereinafter, referred to as LDO) 4; a booster circuit 5 implemented by a DC/DC converter; the MCU 6; a load switch (hereinafter, referred to as LSW) 7 configured by combining a capacitor, a resistor, a transistor, and the like; a multiplexer 8; a flip-flop (hereinafter, referred to as FF) 9; an AND gate (simply referred to as "AND" in FIG. 9) 10; a booster circuit 11 implemented by a DC/DC converter; an operational amplifier OP1; and an operational amplifier OP2.

The main substrate 20 is further provided with switches Q1 to Q9 each implemented by a metal-oxide-semiconductor field-effect transistor (MOSFET), resistors R1 to R12, RA, and RB each a having fixed electric resistance value, a capacitor C1, a capacitor C2, a varistor V, a varistor V1, a reactor L3 connected to the charging IC 3, a reactor L5 connected to the booster circuit 5, and a reactor L11 connected to the booster circuit 11. Each of the switch Q3, the switch Q4, the switch Q7, the switch Q8, and the switch Q9 is implemented by an N-channel MOSFET. Each of the switch Q1, the switch Q2, the switch Q5, and the switch Q6 is implemented by a P-channel MOSFET. Each of the switches Q1 to Q8 is switched between an ON state and an OFF state by controlling a potential of the gate terminal by the MCU 6.

In FIG. 9, various terminals are denoted by reference numerals in each IC except for the operational amplifier. A terminal VCC and a terminal VDD mounted on the chip each indicate a power supply terminal on a high potential side. A terminal VSS and a terminal GND mounted on the chip each indicate a low-potential-side (reference-potential-side) power supply terminal. In the electronic component formed into a chip, a difference between a potential of the power supply terminal on the high potential side and a potential of the power supply terminal on the low potential side is a power supply voltage (an operating voltage). The electronic component formed into a chip executes various functions by using the power supply voltage.

In FIG. 9, the terminal GND and the terminal VSS of each IC except for the operational amplifier are connected to the ground line. Further, the terminal GND of the charging terminal 1, a negative power supply terminal of the operational amplifier OP1, and a negative power supply terminal of the operational amplifier OP2 are connected to the ground line.

The battery connector 20D (see a vicinity of a left center part in FIG. 9) provided on the main substrate 20 includes a terminal BAT connected to each of a detection terminal SNS of the charging IC 3 and a charging terminal BAT of the charging IC 3; a terminal GND connected to the ground line of the main substrate 20; and a terminal TH3 connected to a terminal P25 of the MCU 6. The terminal BAT of the battery connector 20D is connected, by the lead wire 16, to a positive terminal of the power supply ba provided in the battery pack BP. The terminal TH3 of the battery connector 20D is connected, by the lead wire 16, to a positive terminal of a power supply thermistor th3 provided in the battery pack BP. The terminal GND of the battery connector 20D is connected, by lead wire 16, to a negative terminal of the power supply ba and a negative terminal of the power supply thermistor th3.

The OLED connector 20C (see a vicinity of a lower left part in FIG. 9) provided on the main substrate 20 includes a terminal VCC_R connected to an output terminal VOUT of the booster circuit 5; a terminal VDD connected to an output terminal OUT of the LDO 4; a terminal RSTB connected to a terminal P24 of the MCU 6; a communication terminal T3 connected to a communication terminal P28 of the MCU 6 by a signal line SL; and a terminal VSS connected to the ground line of the main substrate 20.

The terminal VCC_R of the OLED connector 20C is connected to a drive voltage supply terminal of the OLED panel 17 by the OLED FPC 25. The terminal VDD of the OLED connector 20C is connected, by the OLED FPC 25, to a power supply terminal of a control IC for controlling the OLED panel 17. A voltage to be supplied to the drive voltage supply terminal of the OLED panel 17 is, for example, about 15 V, which is higher than a voltage to be supplied to the power supply terminal of the control IC of the OLED panel 17. The terminal VSS of the OLED connector 20C is connected, by the OLED FPC 25, to respective ground terminals of the OLED panel 17 and the control IC of the OLED panel 17. The terminal RSTB of the OLED connector 20C is connected, by the OLED FPC 25, to a terminal for restarting the control IC of the OLED panel 17.

The signal line SL connected to the communication terminal T3 of the OLED connector 20C is also connected to a communication terminal T3 of the charging IC 3. Through the signal line SL, the MCU 6 may communicate with the charging IC 3 and the control IC of the OLED panel 17. The signal line SL is used for serial communication, and a plurality of signal lines such as a data line for data transmission and a clock line for synchronization are actually required. It should be noted that, in FIG. 9, the signal line SL is shown as one signal line for simplification. The communication between the MCU 6 and the charging IC 3 and the control IC of the OLED panel 17 may be performed by parallel communication instead of serial communication.

The debug connector 20E (see a vicinity of a lower left part in FIG. 9) provided on the main substrate 20 includes a terminal VMCU connected to the output terminal OUT of the LDO 4; a terminal T1 (one terminal is shown in the drawing, but there are two terminals actually) connected to a communication terminal P23 of the MCU 6; a terminal T2 (one terminal is shown in the drawing, but there are two terminals actually) connected to a communication terminal P22 of the MCU 6; a terminal NRST connected to a terminal P27 of the MCU 6; and a terminal GND connected to the ground line of the main substrate 20. The terminal NRST is also connected to a drain terminal of the switch Q9 whose gate terminal is connected to a drain terminal of the switch Q7 and whose source terminal is connected to the ground line. The debug connector 20E is not used in a normal use state of the aerosol generating device 200, and is used by being connected to a computer prepared by a manufacturer or a seller only when maintenance such as rewriting of information (including a program) stored in the MCU 6 is necessary.

The main connector 20A (see a vicinity of a right center part in FIG. 9) provided on the main substrate 20 includes a terminal PUFF connected to a terminal P19 of the MCU 6; a terminal LED connected to a drain terminal of a switch Q8 whose gate terminal is connected to a terminal P20 of the MCU 6 and whose source terminal is connected to the ground line; a terminal VIB connected to an output terminal OUT of the LSW 7; a terminal VOTG connected to a booster output terminal RN of the charging IC 3; a terminal VMCU connected to the output terminal OUT of the LDO 4 via a resistor R5; a terminal GND connected to the ground line; a terminal KEY connected to the output terminal OUT of the LDO 4 via a voltage dividing circuit including a resistor R4 and a resistor R3 connected in series to the resistor R4; a terminal HT1 (P1) connected to a drain terminal of the switch Q1 whose gate terminal is connected to a terminal P12 of the MCU 6 and whose source terminal is connected to an output terminal VOUT of the booster circuit 11; a terminal HT1 (P2) connected to a drain terminal of the switch Q2 whose gate terminal is connected to a terminal P13 of the MCU 6 and whose source terminal is connected to the output terminal VOUT of the booster circuit 11 and a drain terminal of the switch Q4 whose gate terminal is connected to a terminal P17 of the MCU 6 and whose source terminal is connected to the ground line; and a terminal HT1 (P3) connected to a drain terminal of the switch Q3 whose gate terminal is connected to a terminal P18 of the MCU 6 and whose source terminal is connected to the ground line.

The terminal HT1 (P1) of the main connector 20A is connected, by the main FPC 23, to the input-side contact point P1 connected to the pogo pin p1. The terminal HT1 (P2) of the main connector 20A is connected, by the main FPC 23, to the input-side contact point P2 connected to the pogo pin p2. The terminal HT1 (P3) of the main connector 20Ais connected, by the main FPC 23, to the input-side contact point P3 connected to the pogo pin p3. The terminal KEY of the main connector 20A is connected, by a wiring of the main FPC 23, to one end of the switch BT mounted on the main FPC 23. The other end of the switch BT is connected to a ground line of the main FPC 23.

The heater connector 20B (see a vicinity of an upper right part in FIG. 9) provided on the main substrate 20 includes a first thermistor terminal TH1 connected, via a wiring of the heater FPC 24, to a positive terminal of a first thermistor th1 mounted on the heater FPC 24; a second thermistor terminal TH2 connected, via a wiring of the heater FPC 24, to a positive terminal of a second thermistor th2 mounted on the heater FPC 24; a sheet heater terminal HT2 connected, via a wiring of the heater FPC 24, to a positive terminal of the sheet heater HTR formed by a conductive pattern of the heater FPC 24; and a terminal GND connected to the ground line of the main substrate 20. The heater FPC 24 is provided with wirings connected to a negative terminal of the first thermistor th1, a negative terminal of the second thermistor th2, and a negative terminal of the sheet heater HTR, and the wirings are connected to the terminal GND of the heater connector 20B. The sheet heater terminal HT2 is connected to a drain terminal of the switch Q5 whose gate terminal is connected to a terminal P11 of the MCU 6 and whose source terminal is connected to the output terminal VOUT of the booster circuit 11.

The puff sensor connector 21A connected to the terminal group 15A of the inhalation sensor 15, the connector 21B connected to the main FPC 23, the vibration motor connector 21C connected to the vibration motor 13, the LED 21D, the varistor V, and the capacitor C2 are mounted on the puff sensor substrate 21 (see a vicinity of a lower center part in FIG. 9).

The connector 21B of the puff sensor substrate 21 includes terminals (a terminal PUFF, a terminal LED, a terminal VIB, a terminal VOTG, a terminal VMCU, and a terminal GND) connected by wirings formed on the main FPC 23 to the terminal PUFF, the terminal LED, the terminal VIB, the terminal VOTG, the terminal VMCU, and the terminal GND of the main connector 20A respectively. As described above, the main FPC 23 is provided with the switch BT connected between the terminal KEY of the main connector 20A and the ground line. When the switch BT is pressed down, the terminal KEY is connected to the ground line of the main FPC 23, and a potential of the terminal KEY gets to a ground potential. On the other hand, in a state where the switch BT is not pressed down, the terminal KEY is not connected to the ground line of the main FPC 23, and the potential of the terminal KEY is undefined.

The puff sensor connector 21A of the puff sensor substrate 21 includes a terminal GATE connected to the output terminal of the inhalation sensor 15, a terminal GND connected to the ground terminal of the inhalation sensor 15, and a terminal VDD connected to the power supply terminal of the inhalation sensor 15. The terminal GATE of the puff sensor connector 21A is connected to the terminal PUFF of the connector 21B. The terminal VDD of the puff sensor connector 21A is connected to the terminal VMCU of the connector 21B. The terminal GND of the puff sensor connector 21A is connected to the terminal GND of the connector 21B. One end of the varistor V is connected to a connection line between the terminal GATE of the puff sensor connector 21A and the terminal PUFF of the connector 21B, and the other end of the varistor V is connected to the ground line. Even when a large voltage is input to the terminal GATE from an inhalation sensor 15 side, the varistor V can prevent the voltage from being input to other components of the puff sensor substrate 21 or the MCU 6. One end of the capacitor C2 is connected to a connection line between the terminal VDD of the puff sensor connector 21A and the terminal VMCU of the connector 21B, and the other end of the capacitor C2 is connected to the ground line. Even when an unstable voltage is input to the terminal VDD of the puff sensor connector 21A from a main substrate 20 side via the capacitor C2, a voltage smoothed by the capacitor C2 may be input to the inhalation sensor 15.

The vibration motor connector 21C of the puff sensor substrate 21 includes a positive terminal connected to the terminal VIB of the connector 21B and a negative terminal connected to the ground line. The vibration motor 13 is connected to the positive terminal and the negative terminal.

The LED 21D of the puff sensor substrate 21 has an anode connected to the terminal VOTG of the connector 21B and a cathode connected to the terminal LED of the connector 21B.

The charging terminal 1 on an upper left part in FIG. 9 includes four terminals GND and four power supply input terminals BUS. Each power supply input terminal BUS of the charging terminal 1 is connected in parallel to an input terminal VIN of the protection IC 2. In a state where a USB plug is connected to the charging terminal 1 and a USB cable including the USB plug is connected to an external power supply, that is, in a state where the USB connection is established, a USB voltage V_{USB} is input to the input terminal VIN of the protection IC 2 via the power supply input terminal BUS of the charging terminal 1.

The protection IC 2 adjusts the USB voltage V_{USB} input to the input terminal VIN, and outputs a bus voltage V_{BUS} of a predetermined value (hereinafter, for example, 5.0 V) from an output terminal OUT. The charging IC 3, a voltage dividing circuit implemented by a series circuit including a resistor R1 and a resistor R2, and a switch Q7 are connected in parallel to the output terminal OUT of the protection IC 2. Specifically, the output terminal OUT of the protection IC 2 is connected to one end of the resistor R2 constituting the voltage dividing circuit, an input terminal VBUS of the charging IC 3, and the drain terminal of the switch Q7 whose gate terminal is connected to a terminal P21 of the MCU 6 and whose source terminal is connected to the ground line. One end of the resistor R1 is connected to the other end of the resistor R2, and the other end of the resistor R1 is connected to the ground line. A node connecting the resistor R1 and the resistor R2 is connected to a terminal P2 of the MCU 6. The protection IC 2 outputs the bus voltage V_{BUS} from the output terminal OUT in a state where a low level signal is input from the MCU 6 to a negative logic enable terminal CE(⁻), and stops outputting the bus voltage V_{BUS} from the output terminal OUT in a state where a high level signal is input from the MCU 6 to the enable terminal CE(⁻).

The charging IC 3 has a charging function of charging the power supply ba based on the bus voltage V_{BUS} input to the input terminal VBUS. The charging IC 3 acquires a charging current and a charging voltage of the power supply ba by a detection terminal SNS, and performs a charging control on the power supply ba (a control on power supply from the charging terminal BAT to the power supply ba) based on the charging current and the charging voltage. Further, the charging IC 3 acquires temperature information of the power supply ba, that is acquired by the MCU 6 from the electric power supply thermistor th3 via the terminal P25, from the MCU 6 by serial communication using the signal line SL, and uses the temperature information for the charging control.

The charging IC 3 has a first function of generating a system power supply voltage V_{SYS} from a voltage (hereinafter, referred to as a power supply voltage V_{BAT}) of the power supply ba input to the charging terminal BAT and outputting the system power supply voltage V_{SYS} from an output terminal SYS, a second function of generating the system power supply voltage V_{SYS} from the bus voltage V_{BUS} input to the input terminal VBUS and outputting the system power supply voltage V_{SYS} from the output terminal SYS, and a third function of outputting, from a booster output terminal RN, an OTG voltage V_{OTG} (for example, a voltage of 5 V) obtained by boosting the power supply voltage V_{BAT} input to the charging terminal BAT. The second function is enabled only in a state where the USB connection is established. As described above, the system power supply voltage V_{SYS} and the OTG voltage V_{OTG} are in a normal state where the power supply ba can supply electric power to the charging IC 3, and if the charging IC 3 is operating normally, output from the charging IC 3 is constantly possible.

One end of the reactor L3 is connected to a switching terminal SW of the charging IC 3. The other end of the reactor L3 is connected to the output terminal SYS of the charging IC 3. The charging IC 3 includes a negative logic enable terminal CE(⁻), and the enable terminal CE(⁻) is connected to a terminal P1 of the MCU 6. When a high level signal is input to the terminal P2 by establishing the USB connection, the MCU 6 controls a potential of the terminal P1 to get to a low level, and thereby charging control of the charging IC 3 on the power supply ba is permitted and the second function is enabled.

The charging IC 3 further includes a negative logic terminal QON( ). The terminal QON( ) is connected to a node N2 connecting the resistor R3 and the resistor R4, and the node N2 is connected to the terminal P21 of the MCU 6. When a low level signal is input to the terminal QON( ), the charging IC 3 stops the voltage output from the output terminal SYS.

The LDO 4, the booster circuit 5, and the booster circuit 11 are connected in parallel to the output terminal SYS of the charging IC 3. Specifically, the output terminal SYS of the charging IC 3 is connected to a control terminal CTL and an input terminal IN of the LDO 4, an input terminal VIN of the booster circuit 5, and an input terminal VIN of the booster circuit 11. The OTG voltage V_{OTG} output from the booster output terminal RN of the charging IC 3 is supplied to the anode of the LED 21D via the terminal VOTG of the main connector 20A and the terminal VOTG of the connector 21B. A cathode of the LED 21D is connected to ground via the terminal LED of the connector 21B, the terminal LED of the main connector 20A, and the switch Q8. Therefore, by the MCU 6 performing an ON/OFF control of the switch Q8, a lighting control on the LED 21D using the OTG voltage V_{OTG} may be performed.

The booster circuit 5 includes a switching terminal SW, a positive logic enable terminal EN connected to a terminal P26 of the MCU 6, an output terminal VOUT, and a terminal GND. One end of the reactor L5 is connected to the switching terminal SW of the booster circuit 5. The other end of the reactor L5 is connected to the input terminal VIN of the booster circuit 5. The booster circuit 5 performs an ON/OFF control of a built-in transistor connected to the switching terminal SW, thereby boosting a voltage input to the switching terminal SW via the reactor L5 and outputting the boosted voltage from the output terminal VOUT. An OLED voltage V_{OLED} output from the output terminal VOUT of the booster circuit 5 is a sufficiently high voltage suitable for driving the OLED panel 17, and is a voltage of 15 V as an example. The input terminal VIN of the booster circuit 5 constitutes a high-potential-side power supply terminal of the booster circuit 5. The booster circuit 5 outputs the OLED voltage V_{OLED} when a signal input from the terminal P26 of the MCU 6 to the enable terminal EN gets to a high level, and stops outputting the OLED voltage V_{OLED} when the signal input from the terminal P26 of the MCU 6 to the enable terminal EN gets to a low level. In this manner, the OLED panel 17 is driven and controlled by the MCU 6.

The booster circuit 11 includes an input terminal VIN, a switching terminal SW, an output terminal VOUT, a positive logic enable terminal EN, and a terminal GND. One end of the reactor L11 is connected to the switching terminal SW of the booster circuit 11. The other end of the reactor L11 is connected to the input terminal VIN of the booster circuit 11. The booster circuit 11 performs an ON/OFF control of a built-in transistor connected to the switching terminal SW, thereby boosting a voltage input to the switching terminal SW via the reactor L11 and outputting the boosted voltage from the output terminal VOUT. A heating voltage V_{HEAT} output from the output terminal VOUT of the booster circuit 11 is, for example, a voltage of 4 V The input terminal VIN of the booster circuit 11 constitutes a high-potential-side power supply terminal of the booster circuit 11. The booster circuit 11 outputs the heating voltage V_{HEAT} when a signal input from an output terminal Y of the AND gate 10 to be described later to the enable terminal EN gets to a high level, and stops outputting the heating voltage V_{HEAT} when the signal input to the enable terminal EN gets to a low level.

The capacitor C1, a voltage dividing circuit implemented by a series circuit including a resistor R7 and a resistor R6, the multiplexer 8, the switch Q1, the switch Q2, and the switch Q5 are connected in parallel to the output terminal VOUT of the booster circuit 11. Specifically, the output terminal VOUT of the booster circuit 11 is connected to one end of the capacitor C1 the other end of which is connected to the ground line; an input terminal of the voltage dividing circuit including the resistor R6 connected to the ground line and the resistor R7 connected in series to the resistor R6 (a terminal opposite to a resistor R6 side of the resistor R7); a terminal VCC of the multiplexer 8; a source terminal of the switch Q1; a source terminal of the switch Q2; and a source terminal of the switch Q5.

A resistor RA having an electric resistance value Ra is connected in parallel to the switch Q1. A resistor RB having an electric resistance value Rb is connected in parallel to the switch Q2.

The multiplexer 8 includes an input terminal B0, an input terminal B1, an output terminal A, and a select terminal SE. The multiplexer 8 switches between a state where the input terminal B0 and the output terminal A are connected and a state where the input terminal B1 and the output terminal A are connected according to a control signal input from a terminal P15 of the MCU 6 to the select terminal SE.

The input terminal B0 of the multiplexer 8 is connected to a line connecting the switch Q1 and the terminal HT1 (P1). The input terminal B1 of the multiplexer 8 is connected to a line connecting the switch Q2 and the terminal HT1 (P2). The output terminal A of the multiplexer 8 is connected to a noninverting input terminal of the operational amplifier OP1. An inverting input terminal of the operational amplifier OP1 is connected to a node connecting the resistor R7 and the resistor R6. An output terminal of the operational amplifier OP1 is connected to a terminal P14 of the MCU 6.

In a state where a signal input to the control terminal CTL is at a high level (in other words, a state where the system power supply voltage V_{SYS} is output from the output terminal SYS of the charging IC 3), the LDO 4 converts a voltage input to the input terminal VIN (that is, the system power supply voltage V_{SYS}) and outputs the obtained voltage as a system power supply voltage V_{MCU} from the output terminal OUT. The system power supply voltage V_{SYS} is a value in a range of 3.5 V to 4.2 V as an example, and the system power supply voltage V_{MCU} is 3.1 V as an example.

The control IC of the OLED panel 17, the MCU 6, the LSW 7, the inhalation sensor 15, a series circuit including the resistor R3, the resistor R4, and the switch BT, and the debug connector 20E are connected in parallel to the output terminal OUT of the LDO 4. Specifically, the output terminal OUT of the LDO 4 is connected to the terminal VDD of the OLED connector 20C, a terminal VDD of the MCU 6, an input terminal VIN of the LSW 7, one end (a node N1 in the drawing) of the resistor R5 the other end of which is connected to a terminal VMCU of the main connector 20A, an input end (the node N1 in the drawing) of the voltage dividing circuit including the resistor R4 and the resistor R3, and the terminal VMCU of the debug connector 20E.

Further, the output terminal OUT of the LDO 4 is connected to a source terminal of the switch Q6 whose gate terminal is connected to a terminal P4 of the MCU 6. A terminal VCC of the AND gate 10, a terminal VCC of the FF9, one end of a resistor R11, one end of a resistor R12, a positive power supply terminal of the operational amplifier OP2, one end of a resistor R8, one end of a resistor R9, and a positive power supply terminal of the operational amplifier OP1 are connected in parallel to a drain terminal of the switch Q6.

The other end of the resistor R12 is connected to the second thermistor terminal TH2, and a series circuit including the resistor R12 and the second thermistor th2 connected to the second thermistor terminal TH2 constitutes a voltage dividing circuit to which the system power supply voltage V_{MCU} is applied. An output of the voltage dividing circuit corresponds to an electric resistance value (in other words, a temperature) of the second thermistor th2, and is input to the terminal P8 of the MCU 6. Thus, the MCU 6 may acquire the temperature of the second thermistor th2. In the present embodiment, as the second thermistor th2, a thermistor having the NTC characteristic in which the resistance value decreases as the temperature increases is used, but a thermistor having the PTC characteristic in which the resistance value increases as the temperature increases may be used.

One end of a resistor R10 is connected to the other end of the resistor R9, and the other end of the resistor R10 is connected to the ground line. A series circuit including the resistor R9 and the resistor R10 constitutes a voltage dividing circuit to which the system power supply voltage V_{MCU} is applied. An output of the voltage dividing circuit is connected to an inverting input terminal of the operational amplifier OP2, and a fixed voltage value is input to the inverting input terminal. The other end of the resistor R8 is connected to a noninverting input terminal of the operational amplifier OP2.

The other end of the resistor R8 is further connected to the first thermistor terminal TH1 and a terminal P9 of the MCU 6. A series circuit including the resistor R8 and the first thermistor th1 connected to the first thermistor terminal TH1 constitutes a voltage dividing circuit to which the system power supply voltage V_{MCU} is applied. An output of the voltage dividing circuit corresponds to an electric resistance value (in other words, a temperature) of the first thermistor th1, and is input to the terminal P9 of the MCU 6. Accordingly, the MCU 6 may acquire the temperature of the first thermistor th1 (in other words, a temperature of the sheet heater HTR). Further, an output of the voltage dividing circuit is also input to the noninverting input terminal of the operational amplifier OP2. In the present embodiment, as the first thermistor th1, a thermistor having the NTC characteristic in which the resistance value decreases as the temperature increases is used. Therefore, an output of the operational amplifier OP2 gets to a low level when the temperature of the first thermistor th1 (the temperature of the sheet heater HTR) increases and the temperature is equal to or higher than a threshold THD1. In other words, as long as the temperature of the first thermistor th1 (the temperature of the sheet heater HTR) is in a normal range, the output of the operational amplifier OP2 is at a high level.

In a case where a thermistor having the PTC characteristic in which the resistance value increases as the temperature increases is used as the first thermistor th1, an output of the voltage dividing circuit including the first thermistor th1 and the resistor R8 may be connected to the inverting input terminal of the operational amplifier OP2, and an output of the voltage dividing circuit including the resistor R9 and the resistor R10 may be connected to the noninverting input terminal of the operational amplifier OP2. In this case, when the temperature of the first thermistor th1 (the temperature of the sheet heater HTR) increases and the temperature is equal to or higher than the threshold THD1, the output of the operational amplifier OP2 also gets to a low level.

An output terminal of the operational amplifier OP2 is connected to an input terminal D of the FF9. The other end of the resistor R11 and a negative logic clear terminal CLR(⁻) provided in the FF9 are connected to a node connecting the input terminal D of the FF9 and the output terminal of the operational amplifier OP2. That is, the input terminal D of the FF9, the clear terminal CLR(⁻) of the FF9, and the output terminal of the operational amplifier OP2 are pulled up to a supply line of the system power supply voltage V_{MCU} by the resistor R11.

The FF9 has a clock terminal CLK, the clock terminal CLK is connected to a terminal P7 of the MCU 6. The FF9 has an output terminal Q, and the output terminal Q is connected to an input terminal B of the AND gate 10. In a state where a clock signal is input from the MCU 6 to the clock terminal CLK and a high level signal is input to the clear terminal CLR( ), the FF9 holds data (high or low data) according to a level of a signal input to the input terminal D and outputs the held data from the output terminal Q. In a state where the clock signal is input from the MCU 6 to the clock terminal CLK and the low level signal is input to the clear terminal CLR( ), the FF 9 performs reset processing of outputting the low level signal from the output terminal Q regardless of the held data. The reset processing is cancelled by re-inputting a clock signal to the clock terminal CLK in a state where a high level signal is input to the clear terminal CLR( ). That is, the supply of the clock signal to the clock terminal CLK is stopped in a state where a high level signal is input to the clear terminal CLR( ), and then the supply of the clock signal is resumed, thus cancelling the reset processing.

An input terminal A of the AND gate 10 is connected to a terminal P6 of the MCU 6. The output terminal Y of the AND gate 10 is connected to a positive logic enable terminal EN of the booster circuit 11. The AND gate 10 outputs a high level signal from the output terminal Y only in a state where both the signal input to the input terminal A and the signal input to the input terminal B are at a high level.

When a control signal is input to a control terminal CTL from a terminal P10 of the MCU 6, the LSW 7 outputs, from the output terminal OUT, the system power supply voltage V_{MCU} input to the input terminal VIN. The output terminal OUT of the LSW 7 is connected to the vibration motor 13 via the terminal VIB of the main substrate 20 and the terminal VIB of the puff sensor substrate 21. Therefore, when the MCU 6 inputs the control signal to the LSW 7, the vibration motor 13 may be operated using the system power supply voltage V_{MCU}.

### (Transition from Standby Mode to Heating Mode)

The power supply unit 100 has, as operation modes, a sleep mode in which power saving is achieved, a standby mode in which transition from the sleep mode is possible, and a heating mode in which transition from the standby mode is possible (a mode in which the liquid heater or the sheet heater HTR performs heating and aerosol is generated). When a specific operation (for example, a long-press operation) on the switch BT is detected in the sleep mode, the MCU 6 switches the operation mode to the standby mode. When a specific operation (for example, a short-press operation) on the switch BT is detected in the standby mode, the MCU 6 switches the operation mode to the heating mode.

### (Operation of Heating Mode)

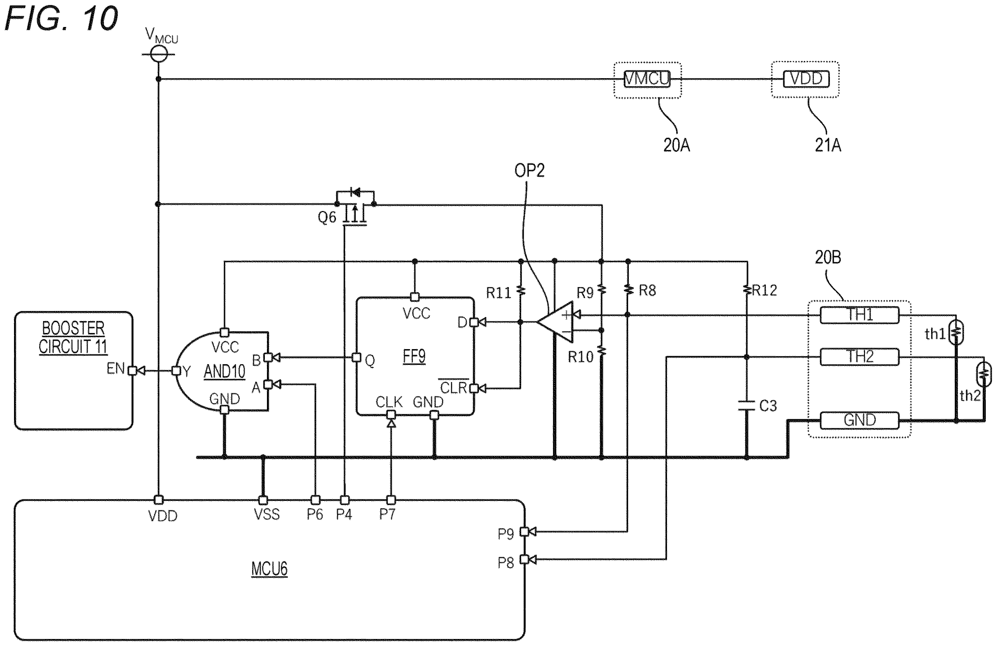

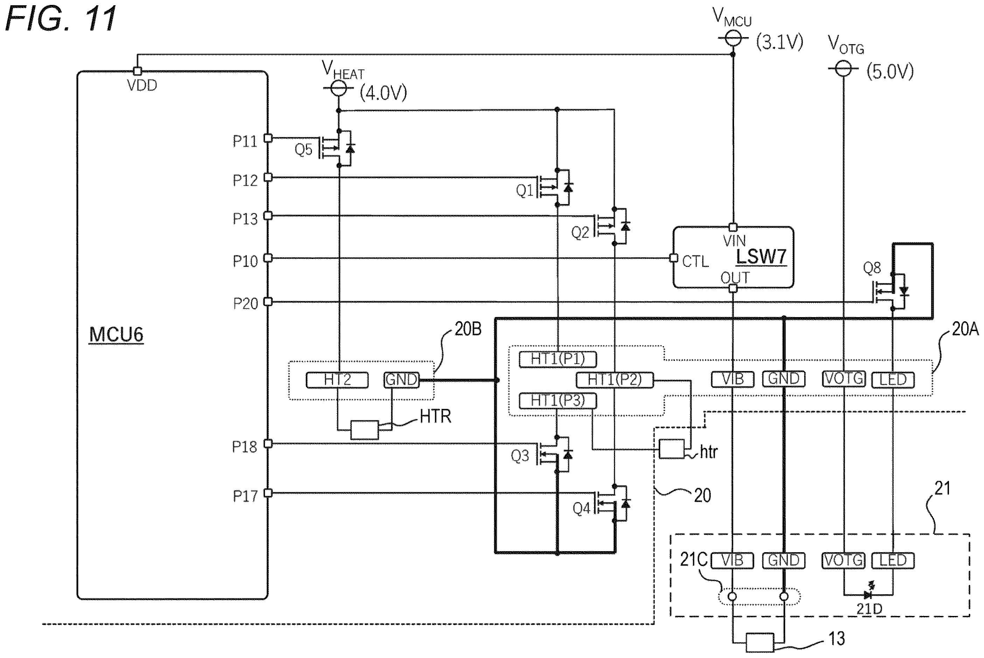

FIG. 10 is a circuit diagram showing electronic components related to an operation in the heating mode and extracted from the circuit shown in FIG. 9. In FIG. 10, a capacitor C3 not shown in FIG. 9 is additionally shown. FIG. 11 is a circuit diagram showing electronic components related to a heating control of the sheet heater HTR and the liquid heater, a driving control of the vibration motor 13, and a driving control of the LED 21D and extracted from the circuit shown in FIG. 9. Hereinafter, the operation in the heating mode will be described with reference to FIGs. 10 and 11.

When transitioning to the heating mode, the MCU 6 controls the switch Q6 shown in FIG. 10 to an ON state. Thus, the system power supply voltage V_{MCU} is supplied to the AND gate 10, the FF9, the resistor R11, the operational amplifier OP2, the resistor R11, the voltage dividing circuit including the resistor R9 and the resistor R10, the voltage dividing circuit including the resistor R8 and the first thermistor th1, the voltage dividing circuit including the resistor R12 and the second thermistor th2, and the operational amplifier OP1. Further, when transitioning to the heating mode, the MCU 6 controls a signal input from the terminal P6 to the input terminal A of the AND gate 10 to get to a high level. The MCU 6 starts inputting the clock signal to the clock terminal CLK of the FF9. In this state, as long as the temperature of the first thermistor th1 (the temperature of the sheet heater HTR) is in a normal range (less than the threshold THD1), the output of the operational amplifier OP2 is at a high level, as a result, the output of the FF9 is at a high level, and as a result, the output of the AND gate 10 is at a high level. Therefore, the booster circuit 11 starts outputting the heating voltage V_{HEAT}, and heating of the sheet heater HTR and the liquid heater is possible.

### (Determination of Connection Destination of Liquid Heater)

When the booster circuit 11 starts outputting the heating voltage V_{HEAT}, as shown in FIG. 11, electric power may be supplied to the sheet heater HTR connected to the sheet heater terminal HT2, and a liquid heater connected to any two of the terminals HT1 (P1) to the terminal HT1 (P3) (in FIG. 11, a liquid heater htr connected to the terminal HT1 (P1) and the terminal HT1 (P2) is shown). In this state, first, the MCU 6 determines, based on the output of the operational amplifier OP1 shown in FIG. 9, to which pair among the pogo pin p1, the pogo pin p2, and the pogo pin p3 the liquid heater is connected. The determination processing includes the following first step, second step, and third step.

### (First Step)

The MCU 6 performs a control to connect the input terminal B0 and the output terminal A of the multiplexer 8 in a state where only the switch Q4 among the switches Q1 to Q4 is controlled to an ON state. In this state, when it is assumed that an electric resistance value between the terminal HT1 (P1) and the terminal HT1 (P2) is Rx, a divided voltage value = V_{HEAT} * {Rx/(Ra + Rx)} is input to the noninverting input terminal of the operational amplifier OP1. In the operational amplifier OP1, the voltage input to the noninverting input terminal is compared with the value of the divided voltage value when the liquid heater is connected between the terminal HT1 (P1) and the terminal HT1 (P2), and if the difference is small, the output of the operational amplifier OP1 gets to a low level. Therefore, when the output of the operational amplifier OP1 gets to a low level, the MCU 6 determines that the liquid heater is connected between the terminal HT1 (P1) and the terminal HT1 (P2).

### (Second Step)

When the output of the operational amplifier OP1 gets to a high level in the first step, the MCU 6 performs a control to connect the input terminal B0 and the output terminal A of the multiplexer 8 in a state where only the switch Q3 among the switches Q1 to Q4 is controlled to an ON state. In this state, when the liquid heater is connected between the terminal HT1 (P1) and the terminal HT1 (P3), the output of the operational amplifier OP1 gets to a low level. Therefore, when the output of the operational amplifier OP1 gets to a low level, the MCU 6 determines that the liquid heater is connected between the terminal HT1 (P1) and the terminal HT1 (P3).

### (Third Step)

When the output of the operational amplifier OP1 gets to a high level in the second step, the MCU 6 performs a control to connect the input terminal B1 and the output terminal A of the multiplexer 8 in a state where only the switch Q3 among the switches Q1 to Q4 is controlled to an ON state. In this state, when the liquid heater is connected between the terminal HT1 (P2) and the terminal HT1 (P3), the output of the operational amplifier OP1 gets to a low level. Therefore, when the output of the operational amplifier OP1 gets to a low level, the MCU 6 determines that the liquid heater is connected between the terminal HT1 (P2) and the terminal HT1 (P3).

When the output of the operational amplifier OP1 does not get to a low level in any of the first step to the third step, the MCU 6 issues an error notification.

### (Start of Heating Control)

When a level of the output of the inhalation sensor 15 is changed to a value corresponding to the inhalation performed by the user in a state where the determination processing is finished, the MCU 6 starts the heating control of the sheet heater HTR and the liquid heater. Specifically, the MCU 6 performs the heating control of the sheet heater HTR by performing an ON/OFF control (for example, a PWM control or a PFM control) of the switch Q5 shown in FIG. 11. At this time, the MCU 6 performs, based on the temperature of the second thermistor th2 (in other words, the temperature of the sheet heater HTR) acquired from the signal input to the terminal P8, the heating control of the sheet heater HTR such that the temperature of the sheet heater HTR converges to a target temperature. As the heating control, for example, a Proportional-Integral-Differential (PID) control is used.

In addition, when the liquid heater is connected between the terminal HT1 (P1) and the terminal HT1 (P2), the MCU 6 performs the heating control of the liquid heater by controlling the switch Q4 to an ON state, controlling the switch Q2 and the switch Q3 to an OFF state, and performing an ON/OFF control (for example, the PWM control or the PFM control) on the switch Q1 among the switches Q1 to Q4 shown in FIG. 11. When the liquid heater is connected between the terminal HT1 (P1) and the terminal HT1 (P3), the MCU 6 performs the heating control of the liquid heater by controlling the switch Q3 to an ON state, controlling the switch Q2 and the switch Q4 to an OFF state, and performing an ON/OFF control on the switch Q1 among the switches Q1 to Q4. When the liquid heater is connected between the terminal HT1 (P2) and the terminal HT1 (P3), the MCU 6 performs the heating control of the liquid heater by controlling the switch Q3 to an ON state, controlling the switch Q1 and the switch Q4 to an OFF state, and performing an ON/OFF control on the switch Q2 among the switches Q1 to Q4.

### (Overheating Protection of Heater)

In the power supply unit 100, in the heating mode, electric resistance values of the resistor R8, the resistor R9, and the resistor R10 are determined such that the output of the operational amplifier OP2 gets to a low level when the temperature of the first thermistor th1 is equal to or higher than the threshold THD1. When the temperature of the first thermistor th1 is equal to or higher than the threshold THD1 and the output of the operational amplifier OP2 gets to a low level, a low level signal is input to the clear terminal CLR( ) of the FF9. As a result, since the negative logic clear terminal CLR(⁻) is enabled and the output of the FF9 is forcibly changed to a low level, the output of the AND gate 10 also gets to a low level, and the booster circuit 11 stops outputting the heating voltage V_{HEAT}. As described above, since the output signal of the operational amplifier OP2 is input to the booster circuit 11 capable of reliably stopping the power supply to the sheet heater HTR, safety when the sheet heater HTR reaches a high temperature may be enhanced.

In order to return the output of the FF9 to a high level, it is necessary for the MCU 6 to re-input a clock signal to the clock terminal CLK of the FF9 (in other words, restart the FF9). That is, even if the temperature of the first thermistor th1 returns to less than the threshold THD1 after the output from the booster circuit 11 is stopped, the output from the booster circuit 11 is not resumed unless the MCU 6 performs the restart processing of the FF9.

It is assumed that a cause of the temperature of the first thermistor th1 becoming equal to or higher than the threshold THD1 is freezing of the MCU 6. In this case, a high level signal is continuously input to the input terminal A of the AND gate 10, and a clock signal is continuously input to the FF9. Although details will be described later, the aerosol generating device 200 is provided with a restart circuit RBT (see FIG. 12) capable of restarting (resetting) the MCU 6 by the user operating the switch BT. When a cause of the protection circuit functioning is freezing of the MCU 6, the MCU 6 is restarted by the user. When the MCU 6 is restarted, the FF9 is restarted. When the MCU 6 is restarted, the signal input to the input terminal A of the AND gate 10 gets to a low level. Further, since the switch Q6 is in an OFF state at a timing when the MCU 6 is restarted, a potential of the signal of the input terminal B of the AND gate 10 is undefined. Therefore, the output from the booster circuit 11 is not resumed by just restarting the MCU 6. After the MCU 6 is restarted, the operation mode is transitioned to the heating mode by a user operation, and thus the signal input to the input terminal A of the AND gate 10 gets to a high level. Further, by setting the switch Q6 to an ON state, the signal input to the input terminal B of the AND gate 10 gets to a high level. Accordingly, the output from the booster circuit 11 is resumed.

### (Configuration and Operation of Restart Circuit RBT)

FIG. 12 is a circuit diagram showing electronic components related to the restart of the MCU 6 and extracted from the circuit shown in FIG. 9. FIG. 12 shows the restart circuit RBT. The restart circuit RBT includes a voltage dividing circuit including the resistor R3 and the resistor R4, the switch BT, the terminal KEY and the terminal GND of the main connector 20A, the switch Q7, the switch Q9, the charging IC 3, the LDO 4, and the terminal NRST of the debug connector 20E. In the present embodiment, the MCU 6 may be restarted by the restart circuit RBT according to an operation of the switch BT (as an example, a long-press operation) and a command from an external device connected to the debug connector 20E. The MCU 6 is configured to restart when a signal input to the terminal P27 continues to be at a low level for a predetermined time. Further, the charging IC 3 is configured to restart when a signal input to the terminal QON( ) continues to be at a low level for a predetermined time.

### (Reset of MCU 6 Using Switch BT)

First, an operation when the MCU 6 is restarted without using the debug connector 20E will be described.

The resistor R3 and the resistor R4 have such resistance values that an output of the voltage dividing circuit including the resistor R3 and the resistor R4 gets to a high level in a state where the switch BT is not pressed down. Since a high level signal is input to the terminal QON( ) of the charging IC 3, the charging IC 3 is not reset in this state, and the output of the system power supply voltage V_{SYS} from the output terminal SYS is continued. Since the output of the system power supply voltage V_{SYS} is continued, the output of the system power supply voltage V_{MCU} from the output terminal OUT of the LDO 4 is also continued. Therefore, the MCU 6 continues to operate without stopping. Further, a high level signal is input to the gate terminal of the switch Q7. Therefore, when the USB connection is established (when the bus voltage V_{BUS} is output from the charging IC 3), the switch Q7 gets to an ON state, and as a result, a potential of the gate terminal of the switch Q9 gets to a low level (ground level), and the switch Q9 gets to an OFF state. When the switch Q9 is in an OFF state, a potential of the terminal P27 of the MCU 6 is undefined, so that the MCU 6 is not restarted.

The resistor R3 and the resistor R4 have such resistance values that an output of the voltage dividing circuit including the resistor R3 and the resistor R4 gets to a low level in a state where the switch BT is pressed down. In other words, the resistor R3 and the resistor R4 have such resistance values that a value obtained by dividing the system power supply voltage V_{MCU} gets to a low level. Since a low level signal is input to the terminal QON( ) of the charging IC 3, the charging IC 3 stops outputting the system power supply voltage V_{SYS} from the output terminal SYS when this state continues for a predetermined time. When the output of the system power supply voltage V_{SYS} is stopped, the voltage output from the LDO 4 is stopped, the system power supply voltage V_{MCU} is not input to the terminal VDD of the MCU 6, and the MCU 6 is stopped.

Further, a low level signal is input to the gate terminal of the switch Q7. Therefore, when the USB connection is established (when the bus voltage V_{BUS} is output from the charging IC 3), the switch Q7 gets to an OFF state, and as a result, the potential of the gate terminal of the switch Q9 gets to a high level (bus voltage V_{BUS}), and the switch Q9 gets to an ON state. When the switch Q9 gets to an ON state, the potential of the terminal P27 of the MCU 6 gets to a low level (ground level). When the switch BT is continuously pressed down for a predetermined time, a low level signal is input to the terminal P27 of the MCU 6 for a predetermined time, and thus the MCU 6 executes the restart processing. When the press-down of the switch BT ends, the charging IC 3 resumes the output of the system power supply voltage V_{SYS}, so that the system power supply voltage V_{MCU} is input to the terminal VDD of the MCU 6 which is stopped, and the MCU 6 is started up.

### (Reset of MCU 6 Using Debug Connector 20E)

When the MCU 6 is restarted using the debug connector 20E, the USB connection is performed, and then an external device is connected to the debug connector 20E. In this state, if the switch BT is not pressed, the switch Q9 gets to an OFF state, and thus the potential of the terminal P27 of the MCU 6 depends on an input from the external device. Therefore, when an operator operates the external device to input a low-level restart signal to the terminal NRST, the restart signal is continuously input to the terminal P27 for a predetermined time. By receiving the restart signal, the MCU 6 executes the restart processing.

### (Detailed Configuration of Main FPC 23)

Next, the main FPC 23 will be described in detail.

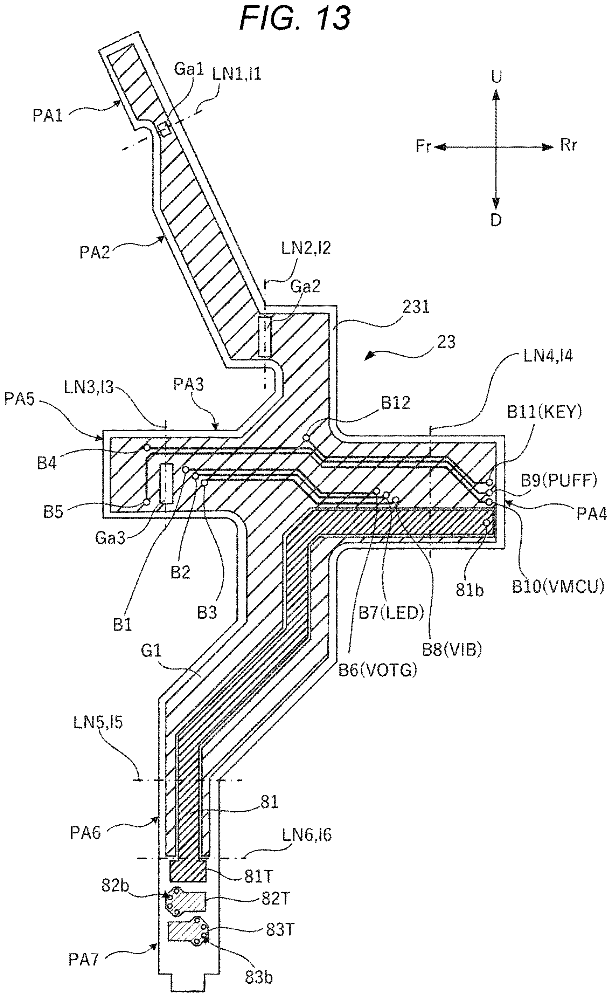

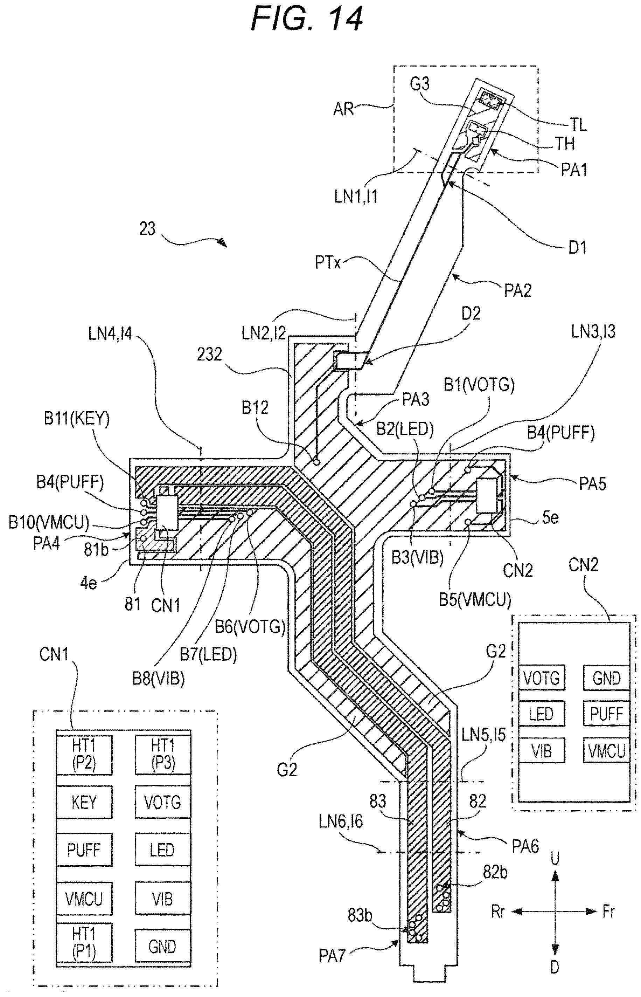

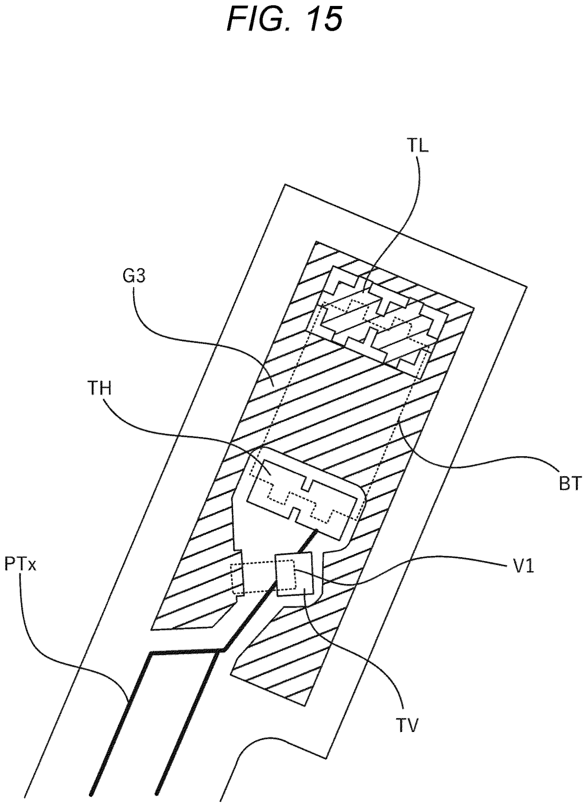

FIG. 13 is a front view of the main FPC 23 as viewed from a left side when the main FPC 23 is developed such that a thickness direction thereof coincides with the left-right direction. FIG. 14 is a front view of the main FPC 23 as viewed from a right side when the main FPC 23 is developed such that the thickness direction thereof coincides with the left-right direction. FIG. 15 is an enlarged view of a range AR shown in FIG. 14.

The main FPC 23 has a two-layer structure including a surface layer 231 (see FIG. 13) disposed on a first case 3A side and a back layer 232 (see FIG. 14) disposed on a right side of the surface layer 231. Conductive patterns and ground patterns each having a reference potential are provided on a left surface of the surface layer 231 and a right surface of the back layer 232, respectively. The conductive patterns formed on the main FPC 23 include conductive patterns 81 to 83 through which electric power for atomizing the aerosol source (electric power supplied to the liquid heater) flows, control conductive patterns each connected to an element (the LED 21D and the vibration motor 13) controlled by the MCU 6, and input conductive patterns each connected to an element (the inhalation sensor 15 and the switch BT) for inputting a signal to the MCU 6. Since the conductive patterns 81 to 83 are used for heating of the liquid heater, large electric power flows therethrough. Therefore, it is preferable that the conductive patterns 81 to 83 have low resistance so as to prevent heat generation and noise and to allow supply of electric power to the liquid heater with high efficiency. The conductive patterns 81 to 83 are larger in width than the control conductive pattern and the input conductive pattern to prevent heat generation and noise.

The main FPC 23 is assembled to the internal unit 2Ain a state where the main FPC 23 is folded along fold lines LN1 to LN6 indicated by straight alternate long and short dash lines in FIGs. 13 and 14. Hereinafter, folds generated by folding along the fold lines LN1 to LN6 are referred to as folds 11 to l6. The main FPC 23 includes a plurality of portions separated by folds l1 to l6. Specifically, the main FPC 23 includes a first portion PA1 on an outer side (end edge side) of the fold 11; a second portion PA2 between the fold l1 and the fold l2; a third portion PA3 on an inner side of the folds l2, l3, l4 and l5; a fourth portion PA4 on an outer side (end edge side) of the fold l4; a fifth portion PA5 on an outer side (end edge side) of the fold l3; a sixth portion PA6 between the fold l5 and the fold l6; and a seventh portion PA7 on an outer side (end edge side) of the fold l6. Among the plurality of portions, the third portion PA3 has a largest plane area.

The main FPC 23 is folded along the fold line LN2 toward a front side and a right side with respect to a paper surface of FIG. 13, and is folded back from front to rear in a state shown in FIG. 4. The main FPC 23 is folded along the fold line LN1 toward the front side with respect to the paper surface of FIG. 13. The main FPC 23 is folded along the fold lines LN3 to LN6 toward a deep side with respect to the paper surface of FIG. 13. The first portion PA1 is fixed to the chassis 50, but the second portion PA2 is in a free state of not being fixed to anywhere. However, as described above, floating of the second portion PA2 is prevented by the heater FPC 24 and the OLED FPC 25. It should be noted that since the second portion PA2 is narrower in width as compared with the third portion PA3 and the folds at both ends extend in different directions, stress is more likely to be applied thereto as compared with other portions.

As described above, since the main FPC 23 is configured to be folded along the fold lines LN1 to LN6, the main FPC 23 can be flexibly routed inside the case 3 while reducing a space occupied by the main FPC 23 in the case 3 as compared with a case where the main FPC 23 is curved. In addition, the more acute a smaller one of angles formed by the portions adjacent to each other with each of the folds 11 to l6 as a boundary, the stronger stress applied to the fold. Accordingly, in order to reduce the stress, the smaller one (folding angle) of the angles formed by the portions adjacent to each other with each of the folds 11 to l6 of the main FPC 23 as a boundary is preferably 90 degrees or more. Thus, durability of the main FPC 23 may be improved.

As shown in FIG. 14, in the fourth portion PA4 of the back layer 232, a substrate connector CN1 is mounted between the fold line LN4 and an end edge 4e of the fourth portion PA4. An enlarged view of the substrate connector CN1 is shown in a region surrounded by a two-dot chain line in FIG. 14. The substrate connector CN1 is a portion connected to the main connector 20A of the main substrate 20, and includes terminals (a terminal KEY, a terminal PUFF, a terminal VMCU, a terminal VOTG, a terminal LED, a terminal VIB, a terminal GND, a terminal HT1 (P1), a terminal HT1 (P2), and a terminal HT1 (P3)) respectively connected to the terminal KEY, the terminal PUFF, the terminal VMCU, the terminal VOTG, the terminal LED, the terminal VIB, the terminal GND, the terminal HT1 (P1), the terminal HT1 (P2), and the terminal HT1 (P3) of the main connector 20A.

Thick lines shown in FIGs. 13 and 14 indicate the conductive patterns made of a conductive material. The terminal KEY of the substrate connector CN1 is connected, by the input conductive pattern, to a via B11 formed adjacent to an end edge 4e side. The via formed in the main FPC 23 electrically connects the conductive pattern on the surface layer 231 and the conductive pattern on the back layer 232, and is a conductor that penetrates the main FPC 23 in the thickness direction and extends in the thickness direction. The terminal PUFF of the substrate connector CN1 is connected, by the input conductive pattern, to a via B9 formed adjacent to the end edge 4e side. The terminal VMCU of the substrate connector CN1 is connected, by the input conductive pattern, to a via B10 formed adjacent to the end edge 4e side. The terminal VOTG of the substrate connector CN1 is connected, by the control conductive pattern, to a via B6 formed in the third portion PA3. The terminal VLED of the substrate connector CN1 is connected, by the control conductive pattern, to a via B7 formed in the third portion PA3. The terminal VIB of the substrate connector CN1 is connected, by a control conductive pattern, to a via B8 formed in the third portion PA3. For each of the via B6 to the via B11, a name of the terminal as a connection destination is described in parentheses.

Each of the via B6 to the via B11 reaches the surface layer 231 as shown in FIG. 13. A via B4 and a via B5 are provided in the fifth portion PA5 of the surface layer 231. On the surface layer 231, an input conductive pattern connecting the via B9 and the via B4 and an input conductive pattern connecting the via B10 and the via B5 are formed. A via B1, a via B2, and a via B3 are provided in a region of the third portion PA3 of the surface layer 231 which is adjacent to the fifth portion PA5. On the surface layer 231, a control conductive pattern connecting the via B6 and the via B1 is formed, a control conductive pattern connecting the via B7 and the via B2 is formed, and a control conductive pattern connecting the via B8 and the via B3 is formed. A via B12 is provided in a region of the third portion PA3 of the surface layer 231 which is close to the second portion PA2. An input conductive pattern connecting the via B11 and the via B12 is formed on the surface layer 231.

As shown in FIG. 14, each of the via B1 to the via B5 and the via B12 reaches the back layer 232. In the fifth portion PA5 of the back layer 232, a substrate connector CN2 is mounted between the fold line LN3 and an end edge 5e of the fifth portion PA5. An enlarged view of the substrate connector CN2 is shown in a region surrounded by a two-dot chain line in FIG. 14. The substrate connector CN2 is a portion connected to the connector 21B of the puff sensor substrate 21, and includes terminals (a terminal VOTG, a terminal LED, a terminal VIB, a terminal GND, a terminal PUFF, and a terminal VMCU) respectively connected to the terminal VOTG, the terminal LED, the terminal VIB, the terminal GND, the terminal PUFF, and the terminal VMCU of the connector 21B.

On the back layer 232, a control conductive pattern connecting the via B1 and the terminal VOTG of the substrate connector CN2, a control conductive pattern connecting the via B2 and the terminal LED of the substrate connector CN2, a control conductive pattern connecting the via B3 and the terminal VIB of the substrate connector CN2, an input conductive pattern connecting the via B4 and the terminal PUFF of the substrate connector CN2, and an input conductive pattern connecting the via B5 and the terminal VMCU of the substrate connector CN2 are formed. In FIG. 14, for each of the via B1 to the via B5, a name of the terminal as a connection destination of the substrate connector CN2 is described in parentheses.

As shown in FIG. 15, in the first portion PA1 of the back layer 232, a terminal TH to which a positive terminal of the switch BT is connected, a terminal TL to which a negative terminal of the switch BT is connected, a ground pattern G3 having a reference potential, and a terminal TV to which a positive terminal of the varistor V1 shown in FIG. 9 is connected are formed. The terminal TL is formed integrally with the ground pattern G3. On the back layer 232, an input conductive pattern PTx connecting the terminal TH and the terminal TV to the via B12 is formed. Even if external noise such as static electricity enters through the switch BT directly mounted on the main FPC 23, the noise does not affect other electric components mounted on the main FPC 23 due to the varistor V1 serving as an overvoltage protection element disposed in a vicinity of the switch BT.

As shown in FIG. 14, the input conductive pattern PTx is parallelized in a portion D1 overlapping the fold line LN1 and parallelized in a portion D2 overlapping the fold line LN2. Specifically, the input conductive pattern PTx branches into two parts at a position on a third portion PA3 side with respect to the fold line LN2, and returns to one part after reaching the second portion PA2 beyond the fold line LN2. Further, the input conductive pattern PTx branches into two parts at a position on a second portion PA2 side with respect to the fold line LN1, and returns to one part after reaching the first portion PA1 beyond the fold line LN1. In the second portion PA2, stress is particularly applied to the fold portions at both ends. Since the input conductive patterns PTx formed in this portion are parallelized, even if one of the two input conductive patterns PTx is disconnected, the input conductive pattern PTx may continue to be used due to the other.

On the back layer 232, one end of the conductive pattern 82 is connected to the terminal HT1 (P2) of the substrate connector CN1. The conductive pattern 82 extends from the terminal HT1 (P2) of the substrate connector CN1 toward the end edge 4e, is folded back toward the third portion PA3, passes through the third portion PA3, and reaches the seventh portion PA7. Four vias 82b are connected to the other end of the conductive pattern 82. As shown in FIG. 13, the four vias 82b reach the seventh portion PA7 of the surface layer 231. A terminal 82T connected to the four vias 82b is provided in the seventh portion PA7 of the surface layer 231.

On the back layer 232, one end of the conductive pattern 83 is connected to the terminal HT1 (P3) of the substrate connector CN1. The conductive pattern 83 extends from the terminal HT1 (P3) of the substrate connector CN1 toward the third portion PA3, passes through the third portion PA3, and reaches the seventh portion PA7. Four vias 83b are connected to the other end of the conductive pattern 83. As shown in FIG. 13, the four vias 83b reach the seventh portion PA7 of the surface layer 231. A terminal 83T connected to the four vias 83b is provided in the seventh portion PA7 of the surface layer 231.

On the back layer 232, one end of the conductive pattern 81 is connected to the terminal HT1 (P1) of the substrate connector CN1. The conductive pattern 81 extends from the terminal HT1 (P1) of the substrate connector CN1 toward the end edge 4e and is formed in the fourth portion PA4. A via 81b is connected to the conductive pattern 81. As shown in FIG. 13, the via 81b reaches the fourth portion PA4 of the surface layer 231. One end of the conductive pattern 81 connected to the via 81b is provided in the fourth portion PA4 of the surface layer 231. The conductive pattern 81 of the surface layer 231 passes through the third portion PA3, and reaches the seventh portion PA7. The other end of the conductive pattern 81 of the surface layer 231 is large in width, and this portion constitutes the terminal 81T.

The seventh portion PA7 is a portion in which the back layer 232 is fixed to a lower surface of the chassis 50 in a state where a thickness direction coincides with the upper-lower direction and is exposed when the lower lid 7a is in the open state. By closing the lower lid 7a, the input-side contact point P1 of the lower lid 7a comes into contact with the terminal 81T, the input-side contact point P2 of the lower lid 7a comes into contact with the terminal 82T, the input-side contact point P3 of the lower lid 7a comes into contact with the terminal 83T, and the pogo pin substrate 22 and the liquid heater are electrically connected to the main FPC 23. As described above, the conductive patterns 81 to 83 come into contact with the input-side contact points P1 to P3 at the terminals 81T to 83T. Therefore, it is preferable that thickness of the conductive patterns 81 to 83 is largest at the terminals 81T to 83T, and is thinner than the terminals 81T to 83T at portions other than the terminals 81T to 83T. Thus, durability of the terminals 81T to 83T may be enhanced.

The conductive patterns 81 to 83 provided on the main FPC 23 are formed over the surface layer 231 and the back layer 232. Therefore, as compared with a configuration in which the conductive patterns 81 to 83 are provided in one layer, the width of each of the conductive patterns 81 to 83 may be increased if an area of the main FPC 23 is the same. Further, a configuration is also conceivable in which the main FPC 23 has, for example, a three-layer structure, and the conductive patterns 81 to 83 are distributed and formed in each layer. As compared with this configuration, the main FPC 23 of the present embodiment has a smaller number of layers, and thus may be simplified in structure and reduced in manufacturing cost and weight. Further, each of the conductive patterns 81 to 83 provided in the main FPC 23 of the present embodiment is configured as one line without branching as the input conductive pattern PTx. In this way, by forming each of the conductive patterns 81 to 83 thick and simple in shape, prevention of disconnection at the folds and prevention of heat and noise due to low resistance and low inductance may be realized.

A width of each of the portions of the main FPC 23 excluding the third portion PA3 and the fourth portion PA4 among the plurality of portions is smaller than a sum of the widths of the conductive patterns 81 to 83. In the present embodiment, the main FPC 23 has a two-layer structure, the conductive pattern 81 is formed on the surface layer 231, and the conductive patterns 82 and 83 are formed on the back layer 232, and thus the width of each of the portions excluding the third portion PA3 and the fourth portion PA4 may be reduced. That is, according to the present embodiment, three thick conductive patterns may be formed without using an excessively large main FPC 23.

As the conductive patterns formed on the surface layer 231, the control conductive pattern connecting the via B1 and the via B6, the control conductive pattern connecting the via B2 and the via B7, and the control conductive pattern connecting the via B3 and the via B8 are formed to extend in the front-rear direction across the conductive pattern 82 and the conductive pattern 83 formed on the back layer 232 in a front view of the main FPC 23. Further, as the conductive patterns formed on the surface layer 231, the input conductive pattern connecting the via B11 and the via B12, the input conductive pattern connecting the via B4 and the via B9, and the input conductive pattern connecting the via B5 and the via B10 are formed to extend in the front-rear direction across the conductive pattern 82 and the conductive pattern 83 formed on the back layer 232 in the front view of the main FPC 23. Thus, the control conductive patterns and the input conductive patterns formed on the surface layer 231 overlap the conductive pattern 82 and the conductive pattern 83 formed on the back layer 232 in the front view of the main FPC 23. With such a configuration, the widths of the conductive pattern 82 and the conductive pattern 83 may be increased without interfering with the control conductive patterns and the input conductive patterns.

As shown in FIG. 13, on the surface layer 231, a ground pattern G1 having a large area is formed across the first portion PA1 to the sixth portion PA6. The ground pattern G1 is provided with a gap Ga3 at a position overlapping the fold line LN3, a gap Ga2 at a position overlapping the fold line LN2, and a gap Ga1 at a position overlapping the fold line LN1. By providing such gaps Ga1 to Ga3, stress applied to the folds 11 to l3 in the ground pattern G1 may be released.

As shown in FIG. 14, on the back layer 232, two ground patterns G2 each having an area smaller than that of the ground pattern G1 are formed across the third portion PA3 to the fifth portion PA5. The ground pattern G2 on a lower left side in the drawing is connected to the terminal GND of the substrate connector CN1. The ground pattern G2 on an upper right side in the drawing is connected to the terminal GND of the substrate connector CN2.

As shown in FIG. 14, on the back layer 232, no ground pattern is formed in the second portion PA2, the sixth portion PA6, and the seventh portion PA7. That is, the ground patterns G2 and the ground pattern G3 are formed to avoid a part (folds 11,12,15, and l6) of the folds l1 to l7. The ground pattern is generally formed of a large-area copper foil, but such a large-area copper foil has few places for stress to escape due to the folds. Therefore, on the back layer 232, no ground pattern is provided at locations of the folds 11,12,15, and l6, thereby ensuring a space for stress to escape.

On the other hand, the ground pattern G1 formed on the surface layer 231 is also formed at positions of the folds 11,12, and l5 where overlapping the ground pattern on the back layer 232 is avoided. That is, the folds overlapping the ground patterns on the surface layer 231 and the back layer 232 are only the folds l3 and l4. In this way, by reducing the number of folds overlapping the ground patterns on each of the surface layer 231 and the back layer 232, an area of the ground patterns may be increased while preventing disconnection of the ground patterns. Stability of the reference potential in the ground pattern greatly depends on an area of the ground pattern. According to the main FPC 23, since the ground patterns are formed over the surface layer 231 and the back layer 232 as described above, the area of the ground patterns may be increased.

Further, in the second portion PA2, no ground pattern is formed on the back layer 232, and the ground pattern G1 is only formed on the surface layer 231. As described above, the second portion PA2 is a portion to which stress is likely to be applied. Therefore, by providing only the input conductive pattern PTx on the back layer 232, flexibility of the second portion PA2 may be ensured and the durability of the main FPC 23 may be improved.

The ground patterns G2 and the ground pattern G3 may be formed avoiding all of the folds 11 to l7. In this case, on the surface layer 231, the ground pattern G1 may be formed on a part or all of the folds l1 to l7.

In the present description, at least the following matters are described. In parentheses, corresponding constituent components and the like in the above-mentioned embodiment are indicated, but the present invention is not limited thereto.
(1) A power supply unit for an aerosol generating device, the power supply unit including:
   a power supply (power supply ba);
   a controller (MCU 6) configured to control supply of electric power from the power supply to an atomizer (liquid heater) that atomizes an aerosol source;
   a flexible circuit substrate (main FPC 23); and
   a switch (switch BT) operable by a user and electrically connected to the controller, in which
   the switch is directly mounted on the flexible circuit substrate.

According to (1), it is not necessary to provide a dedicated rigid circuit substrate for mounting the switch or to use a rigid circuit substrate having a complicated shape. Further, since the flexible circuit substrate may pass through a narrow space, a degree of freedom of arranging the switch is improved while reducing a size and weight of the power supply unit.

(2) The power supply unit for an aerosol generating device according to (1), in which
the flexible circuit substrate includes a fold (folds l1 to l6).

According to (2), as compared with a case where the flexible circuit substrate is curved, the flexible circuit substrate may be routed inside a housing while reducing a space occupied by the flexible circuit substrate in the power supply unit.

(3)The power supply unit for an aerosol generating device according to (1), in which
the flexible circuit substrate includes a plurality of folds (folds 11 to l6) that are folded in different directions.

According to (3), the switch and the controller arranged at appropriate positions may be electrically connected by the flexible circuit substrate capable of taking a complicated shape while reducing the space occupied by the flexible circuit substrate in the power supply unit.

(4)The power supply unit for an aerosol generating device according to (2) or (3), in which
the flexible circuit substrate includes a conductive pattern (input conductive pattern PTx) electrically connecting the switch and the controller, and
a portion (portions D1, D2) of the conductive pattern which is formed at the fold is parallelized.

Since stress is concentrated at the fold, a thin conductive wire pattern may be broken (disconnected). According to (4), since the portion of the conductive pattern which is formed at the fold is parallelized, even if a part of the parallelized conductive patterns is disconnected, use of the conductive pattern may be continued. As a result, durability of the power supply unit is improved.

(5) The power supply unit for an aerosol generating device according to any one of (2) to (4), in which
the flexible circuit substrate includes a ground pattern (ground patterns G1, G2, G3) having a reference potential, and
a portion of the ground pattern which is formed at the fold is provided with a gap (gaps Ga1, Ga2, Ga3).

Since stress is concentrated at the fold, a ground pattern generally having a complicated shape may be broken (disconnected). According to (5), by providing the gap in the ground pattern, a place for the stress to escape may be provided, and thus the durability of the power supply unit is improved.

(6) The power supply unit for an aerosol generating device according to any one of (1) to (5), in which
the flexible circuit substrate includes a first layer (surface layer 231), a second layer (back layer 232), a conductive pattern (input conductive pattern PTx) electrically connecting the switch and the controller and formed on the second layer, and a first ground pattern (ground pattern G1) formed on the first layer and having a reference potential.

Stability of the reference potential in the ground pattern greatly depends on an area of the ground pattern. According to (6), by forming the first ground pattern on the first layer rather than the second layer on which it is difficult to secure the area of the ground pattern because an input conductive pattern is formed, an area of the first ground pattern may be increased. Therefore, the reference potential is stabilized, and an operation of the power supply unit is stabilized.

(7) The power supply unit for an aerosol generating device according to (6), in which
the flexible circuit substrate includes a fold (fold 11 to l6) and a plurality of portions separated by the fold,
the plurality of portions include a first portion (first portion PA1) on which the switch is mounted, a third portion (third portion PA3), and a second portion (second portion PA2) connecting the first portion and the third portion,
the conductive pattern is formed on the second layer of the second portion, and
the first ground pattern is formed only on the first layer of the second portion in the first layer of the second portion and the second layer of the second portion.

According to (7), stress tends to be concentrated on the second portion having folds at both ends. Therefore, the second portion is provided with the ground pattern only on the first layer, so that flexibility of the flexible circuit substrate is ensured and resistance to stress is improved. Accordingly, the durability of the power supply unit is improved. Further, by providing the ground pattern on the first layer rather than the second layer on which the conductive pattern is formed, the area of the ground pattern may be increased, and the operation of the power supply unit is stabilized.

(8) The power supply unit for an aerosol generating device according to (7), in which
the third portion is largest in area among the plurality of portions,
the first ground pattern is further formed on the first layer of the third portion, and
the flexible circuit substrate further includes a second ground pattern (ground pattern G2) formed on the second layer of the third portion and having a reference potential.

According to (8), since the ground pattern is formed on both the first layer and the second layer of the third portion having a large area, the area of the ground pattern may be increased, and the operation of the power supply unit is stabilized.

(9) The power supply unit for an aerosol generating device according to any one of (1) to (8), in which
the flexible circuit substrate includes a conductive pattern (input conductive pattern PTx) electrically connecting the switch and the controller, a third ground pattern (ground pattern G3) having a reference potential, a fold (folds l1 to l6), and a plurality of portions separated by the fold,
the power supply unit further comprises an overvoltage protection element (varistor V1) having one end connected to the switch and the other end connected to the third ground pattern,
the plurality of portions includes a portion (first portion PA1) on which the switch is mounted, and
the overvoltage protection element is mounted on the portion.

According to (9), even if external noise such as static electricity enters through the switch, the noise does not affect other electric components mounted on the flexible circuit substrate due to the overvoltage protection element disposed in a vicinity of the switch. Therefore, the durability of the power supply unit is improved.

### REFERENCE SIGNS LIST

100: power supply unit
6: MCU
23: main FPC
BT: switch

## Claims

1. A power supply unit for an aerosol generating device, the power supply unit comprising:
a power supply;
a controller configured to control supply of electric power from the power supply to an atomizer that atomizes an aerosol source;
a flexible circuit substrate; and
a switch operable by a user and electrically connected to the controller, wherein
the switch is directly mounted on the flexible circuit substrate.

2. The power supply unit for an aerosol generating device according to claim 1, wherein
the flexible circuit substrate includes a fold.

3. The power supply unit for an aerosol generating device according to claim 1, wherein
the flexible circuit substrate includes a plurality of folds that are folded in different directions.

4. The power supply unit for an aerosol generating device according to claim 2 or 3, wherein
the flexible circuit substrate includes a conductive pattern electrically connecting the switch and the controller, and
a portion of the conductive pattern which is formed at the fold is parallelized.

5. The power supply unit for an aerosol generating device according to any one of claims 2 to 4, wherein
the flexible circuit substrate includes a ground pattern having a reference potential, and
a portion of the ground pattern which is formed at the fold is provided with a gap.

6. The power supply unit for an aerosol generating device according to any one of claims 1 to 5, wherein
the flexible circuit substrate includes a first layer, a second layer, a conductive pattern electrically connecting the switch and the controller and formed on the second layer, and a first ground pattern formed on the first layer and having a reference potential.

7. The power supply unit for an aerosol generating device according to claim 6, wherein
the flexible circuit substrate includes a fold and a plurality of portions separated by the fold,
the plurality of portions include a first portion on which the switch is mounted, a third portion, and a second portion connecting the first portion and the third portion,
the conductive pattern is formed on the second layer of the second portion, and
the first ground pattern is formed only on the first layer of the second portion in the first layer of the second portion and the second layer of the second portion.

8. The power supply unit for an aerosol generating device according to claim 7, wherein
the third portion is largest in area among the plurality of portions,
the first ground pattern is further formed on the first layer of the third portion, and
the flexible circuit substrate further includes a second ground pattern formed on the second layer of the third portion and having a reference potential.

9. The power supply unit for an aerosol generating device according to any one of claims 1 to 8, wherein
the flexible circuit substrate includes a conductive pattern electrically connecting the switch and the controller, a third ground pattern having a reference potential, a fold, and a plurality of portions separated by the fold,
the power supply unit further comprises an overvoltage protection element having one end connected to the switch and the other end connected to the third ground pattern,
the plurality of portions includes a portion on which the switch is mounted, and
the overvoltage protection element is mounted on the portion.
